# EUROPÄISCHE PATENTSCHRIFT

(11) **EP 3 447 854 B1**
(45) Veröffentlichungstag und Bekanntmachung des Hinweises auf die Patenterteilung: **23.04.2025**
(21) Anmeldenummer: 18190403.8
(22) Anmeldetag: 23.08.2018
(51) Int. Cl.: H01R 13/6587, H05K 1/02, H01R 12/72, H01R 13/518, H01R 12/70, H05K 1/11

(54) **LEITERPLATTE, VERBINDERSYSTEM UND VERFAHREN**
PRINTED CIRCUIT BOARD, CONNECTOR SYSTEM AND METHOD
CIRCUIT IMPRIMÉ, SYSTÈME DE CONNECTEUR ET PROCÉDÉ

(30) Priorität: 25.08.2017 DE 102017008065; 25.08.2017 DE 102017008087
(43) Veröffentlichungstag der Anmeldung: 27.02.2019
(73) Patentinhaber: Yamaichi Electronics Deutschland GmbH, 85609 Aschheim-Dornach (DE)
(72) Erfinder: Quiter, Michael, 57482 Wenden (DE); Serrano, Jaime Fernández, 80796 München (DE); Michel, Dirk, 85778 Haimhausen (DE)
(74) Vertreter: Müller-Boré & Partner Patentanwälte PartG mbB

(56) Entgegenhaltungen:
- WO-A1-2015/112773
- US-A1- 2010 144 203
- US-A1- 2012 214 344

## Beschreibung

Die Erfindung betrifft eine Leiterplatte zum kartenseitigen und/oder rechnerseitigen Kontaktieren eines Verbindersystems sowie ein Verbindersystem mit einer solchen Leiterplatte. Dabei ist das Verbindersystem zum Verbinden einer PCB-Karte mit einem Zentralrechner eines Kraftfahrzeugs ausgebildet.

Moderne Kraftfahrzeuge werden mit einem Zentralrechner ausgestattet, der diverse Automotive Anwendungen ausführen bzw. steuern kann. Dazu kann der Zentralrechner des Kraftfahrzeugs wie bei einem Mainboard eines PCs oder Notebooks mit einer PCB (Printed Circuit Board) Karte bzw. einer Chipkarte verbunden werden, die für die jeweilige Anwendung spezifisch ist. Es ist daher erforderlich, ein für den Automotive Bereich geeignetes Verbindersystem zwischen einer PCB-Karte und dem Zentralrechner eines Kraftfahrzeugs bereitzustellen.

Im Stand der Technik existieren Netzwerkstecker bzw. Netzwerkverbinder aus dem Bereich der Telekommunikation, die jedoch nicht für den Automotive Bereich konzipiert bzw. geeignet sind. Weiterhin existieren hochpolige Verbinder, die eine Mehrzahl von einzelnen Blechen zur Schirmung der Kontaktelemente aufweisen. Solche Verbinder sind jedoch nicht massentauglich und bereits aus diesem Grund nicht für den Automotive Bereich geeignet.

Ein solches Verbindersystem ist u.a. dazu ausgebildet, über Differential-Pair-Kontaktelemente Differential-Pair-Signale zu übertragen. Diese Differential-Pair-Signale müssen sowohl rechnerseitig als auch kartenseitig so geroutet sein, dass eine Mehrzahl von Differential-Pair-Signalen sicher übertragen werden kann.

Aus dem Dokument WO 2015/112773 A1 ist ein modularer elektrischer Verbinder bekannt mit einem rechtwinkligen Zwischenteil. Der Verbinder dient zum Kontaktieren einer PCB, auf welcher zwischen in Reihen und Spalten angeordneten Kontaktstellen Routing-Kanäle ausgebildet sind.

Aus dem Dokument US 2012/0214344 A1 ist ein breitseitengekoppelter Verbinder bekannt, bei welchem grundsätzlich in Reihen und Spalten angeordnete Differential-Pair-Kontakte um 40° bis 60° relativ zu diesen Reihen und Spalten verkippt angeordnet sind.

Aus dem Dokument US 2010/0144203 A1 ist ein Backplane-Verbindersystem bekannt, das bei Frequenzen von bis zu 25 Gbps arbeiten kann. Aus dem Verbinder ragen Kontakte in Reihen und Spalten. Die Kontakte einer Spalte werden auf einer PCB beidseits der Spalte geroutet.

Es ist daher eine Aufgabe der vorliegenden Erfindung, ein sicheres Routing für ein Verbindersystem zum Verbinden einer PCB-Karte mit einem Zentralrechner eines Kraftfahrzeugs zu ermöglichen, welches den Anforderungen im Automotive Bereich, insbesondere hinsichtlich Stabilität, Signalgüte, Frequenzbereich der Signalübertragung und/oder Massentauglichkeit, genügt. Diese Aufgaben werden durch die Gegenstände der unabhängigen Ansprüche gelöst. Vorteilhafte Ausführungsformen sind Gegenstand der Unteransprüche.

Ein erster Aspekt betrifft eine Leiterplatte zum kartenseitigen und/oder rechnerseitigen Kontaktieren eines Verbindersystems, wobei das Verbindersystem zum Verbinden einer PCB-Karte mit einem Zentralrechner eines Kraftfahrzeugs ausgebildet ist, und wobei durch das Verbindersystem Differential-Pair-Signale entlang von Differential-Pair-Kontaktelementen des Verbindersystems leitbar, also geroutet, sind. Die Leiterplatte weist eine Mehrzahl von Paarkontaktstellen zum Kontaktieren von Differential-Pair-Kontaktelementen des Verbindersystems auf, wobei jede Paarkontaktstelle zwei Einzelkontaktstellen zum Kontaktieren von einzelnen Kontaktelementen des jeweiligen Differential-Pair-Kontaktelements des Verbindersystems aufweist. Weiterhin weist die Leiterplatte zumindest einen ersten Routing-Kanal auf, durch welchen Leiterbahnen zu den Einzelkontaktstellen zumindest einer der Paarkontaktstellen geführt sind. Dabei ist eine erste Gruppe der Paarkontaktstellen hintereinander in einer ersten Reihe auf der Leiterplatte angeordnet, und eine zweite Gruppe der Paarkontaktstellen hintereinander in einer zweiten Reihe auf der Leiterplatte angeordnet, wobei die zweite Reihe etwa parallel zu der ersten Reihe angeordnet und/oder ausgerichtet ist. Durch den ersten Routing-Kanal sind Leiterbahnen zu den beiden Einzelkontaktstellen zumindest einer der Paarkontaktstellen der ersten Gruppe geführt, also geroutet. Der erste Routing-Kanal ist zwischen der ersten Reihe und der zweiten Reihe so angeordnet, dass er etwa parallel zu der ersten und zweiten Reihe angeordnet ist.

Die Leiterplatte kann das Verbindersystem entweder kartenseitig oder rechnerseitig kontaktieren. Kontaktiert die Leiterplatte das Verbindersystem kartenseitig, so kann die Leiterplatte z.B. als genau die PCB-Karte ausgebildet sein, mit der das Verbindersystem den Zentralrechner des Kraftfahrzeugs verbindet. Die Leiterplatte kann das Verbindersystem allerdings auch rechnerseitig kontaktieren, wobei sie z.B. als Bestandteil des Zentralrechners ausgebildet sein kann und/oder mit diesem elektrisch verbunden ist. Allgemein kann die Leiterplatte als eine PCB-Karte ausgebildet sein.

Differential-Pair-Signale werden über zwei üblicherweise benachbart angeordnete einzelne Kontaktelemente eines Differential-Pair-Kontaktelements des Verbindersystems übertragen. Die beiden Einzelkontaktstellen jeder Paarkontaktstelle sind zum elektrischen Kontaktieren dieser beiden einzelnen Kontaktelemente eines Differential-Pair-Kontaktelements des Verbindersystems ausgebildet. An den Einzelkontaktstellen kann die Leiterplatte jeweils eine Bohrung aufweisen zur Aufnahme des zugeordneten Kontaktelements des Verbindersystems. Die Paarkontaktstellen sind zum elektrischen und/oder mechanischen Bonden der Differential-Pair-Kontaktelemente des Verbindersystems ausgebildet.

Die Leiterbahnen der Leiterplatte sind elektrisch leitfähig und zum Übertragen der Differential-Pair-Signale ausgebildet. Dazu kontaktieren die Leiterbahnen die Paarkontaktstellen elektrisch, genauer kontaktiert jeweils eine Leiterbahn genau eine Einzelkontaktstelle jeder Paarkontaktstelle. Dazu weist die Leiterplatte (z.B. zumindest) doppelt so viele Leiterbahnen wie Paarkontaktstellen auf.

Die beiden Einzelkontaktstellen jeder Paarkontaktstelle sind benachbart zueinander auf der Leiterplatte angeordnet. Weiterhin sind sie beabstandet voneinander angeordnet, um ein Übersprechen von Differential-Pair-Signalen zu reduzieren. Hierbei können die beiden Einzelkontaktstellen jeder Paarkontaktstelle in dieselbe Richtung voneinander beabstandet auf der Leiterplatte angeordnet sein, z.B. in eine Richtung senkrecht zu der Reihenrichtung, in welcher die erste und zweite Reihe von Paarkontaktstellen ausgerichtet sind. Mit anderen Worten können die Einzelkontaktstellen benachbart zueinander in Spaltenrichtung angeordnet sein, wobei die Spaltenrichtung etwa senkrecht zur Reihenrichtung angeordnet ist.

Sowohl die Reihenrichtung als auch die Spaltenrichtung sind parallel zu der Leiterplattenebene angeordnet, in welcher die Leiterplatte ausgebildet ist.

Auf der Leiterplatte sind zumindest die erste und die zweite Reihe von Paarkontaktstellen ausgebildet, wobei die Leiterplatte auch mehr als zwei solcher Reihen von Paarkontaktstellen aufweisen kann. Jede Reihe von Paarkontaktstellen weist eine Mehrzahl von Paarkontaktstellen auf, z.B. zumindest zwei oder zumindest drei, bevorzugt genau vier Paarkontaktstellen. Hierbei können alle Reihen von Paarkontaktstellen der Leiterplatte etwa parallel zueinander in Reihenrichtung ausgerichtet sein und/oder gleich viele Paarkontaktstellen aufweisen. Hierbei bildet jede Reihe von Paarkontaktstellen eine Gruppe von Paarkontaktstellen, also z.B. die erste Reihe die erste Gruppe, die zweite Reihe die zweite Gruppe, und ggf. so weiter.

Insgesamt kann die Leiterplatte zwischen etwa 10 und etwa 100 in solchen Reihen angeordnete Paarkontaktstellen aufweisen, bevorzugt zwischen etwa 25 und etwa 70, besonders bevorzugt zwischen etwa 40 und 60 Paarkontaktstellen. In einem Ausführungsbeispiel kann die Leiterplatte genau 48 Paarkontaktstellen aufweisen, welche in 12 Reihen angeordnet sind, wobei jede Reihe genau 4 Paarkontaktstellen aufweist. Jeder Reihe von Paarkontaktstellen kann genau ein Routing-Kanal zugeordnet sein.

Zwischen der ersten Reihe und der zweite Reihe von Paarkontaktstellen ist der erste Routing-Kanal angeordnet. Durch den Routing-Kanal sind zumindest abschnittsweise Leiterbahnen geführt, also geroutet. Dabei sind durch den ersten Routing-Kanal bevorzugt die beiden Leiterbahnen geführt, die die beiden Einzelkontaktstellen zumindest einer Paarkontaktstelle der ersten Reihe kontaktieren. Alternativ können diese beiden Leiterbahnen auch durch unterschiedliche Routing-Kanäle geführt sein, was allerdings beim Übertragen von Differential-Pair-Signalen nicht immer günstig ist.

Dabei sind die Leiterbahnen so ausgebildet, dass sie zunächst (sozusagen in einem Übergangsbereich) von der Paarkontaktstelle weg in den ersten Routing-Kanal hinein verlaufend angeordnet sind, und dann innerhalb des ersten Routing-Kanals parallel und benachbart zur ersten Reihe bis zumindest zu einem Anschlussende der ersten Reihe, an welchem die erste Reihe von Paarkontaktstellen endet. Hierbei kann der erste Routing-Kanal in etwa so lang wie die erste Reihe ausgebildet sein, so dass auch die am weitesten vom Anschlussende entfernt angeordnete Paarkontaktstelle durch den ersten Routing-Kanal geroutet sein kann.

Der erste Routing-Kanal kann zumindest abschnittsweise in etwa geradlinig ausgebildet sein, nämlich zumindest an seinem Abschnitt, der zwischen der ersten und zweiten Reihe von Paarkontaktstellen angeordnet ist. Der erste Routing-Kanal erstreckt sich somit ebenfalls in Reihenrichtung auf der Leiterplatte. Der erste Routing-Kanal kann unmittelbar benachbart zur ersten Reihe von Paarkontaktstellen auf der Leiterplatte ausgebildet sein, d.h. dass zwischen der ersten Reihe von Paarkontaktstellen und dem ersten Routing-Kanal keine weiteren Elemente der Leiterplatte mehr ausgebildet sind. Genauso kann die zweite Reihe von Paarkontaktstellen unmittelbar benachbart zum ersten Routing-Kanal ausgebildet sein, d.h. dass der erste Routing-Kanal genau parallel zu und zwischen der ersten und zweiten Reihe von Paarkontaktstellen angeordnet ist.

Der erste Routing-Kanal stellt eine besonders vorteilhafte Möglichkeit bereit, die Differential-Pair-Signale des Verbindersystems Platz sparend und sicher weiterzuleiten. Hierbei ist der erste Routing-Kanal dazu geeignet, eine hohe Anzahl von Differential-Pair-Signale auf einem engen Raum sicher zu routen, welche von dem Verbindersystem übertragen werden.

Gemäß einer Ausführungsform sind die Leiterbahnen durch den ersten Routing-Kanal zumindest bis zu einem Anschlussende der ersten Reihe geführt. Hierbei kann der erste Routing-Kanal zumindest etwa so lang ausgebildet sein wie die erste Reihe. Der erste Routing-Kanal erstreckt sich somit von der Paarkontaktstelle, zu welcher die Leiterbahnen durch den ersten Routing-Kanal führen, zumindest bis zu einem Anschlussende der ersten Reihe. Dadurch können die Differential-Pair-Signale sicher aus den Reihen und/oder der Matrix (welche vom Verbindersystem vorgegeben ist) von Paarkontaktstellen heraus in einen freien Leiterplattenbereich geroutet sein. Dieser freie Leiterplattenbereich kann außerhalb des Bereichs der Leiterplatte angeordnet sein, der unmittelbar vom Verbindersystem kontaktiert wird und deswegen mehr Platz zur Verfügung stellen, die Differential-Pair-Signale sicher weiterzuleiten.

Gemäß einer Ausführungsform sind durch den ersten Routing-Kanal Leiterbahnen zu den Einzelkontaktstellen einer Mehrzahl von Paarkontaktstellen der ersten Gruppe geführt. Die Leiterbahnen zu den Paarkontaktstellen können dabei nebeneinander und/oder übereinander durch den ersten Routing-Kanal geführt sein. Gemäß einer Ausführungsform sind durch den ersten Routing-Kanal Leiterbahnen zu den beiden Einzelkontaktstellen sämtlicher Paarkontaktstellen der ersten Gruppe geführt, die nicht an einem Anschlussende der ersten Reihe angeordnet sind, zu welchem die Leiterbahnen von den Einzelkontaktstellen weg durch den Routing-Kanal geführt sind. Mit anderen Worten sind hierbei nahezu alle Paarkontaktstellen vollständig durch den ersten Routing-Kanal geroutet, mit Ausnahme derjenigen Paarkontaktstelle, die ohnehin bereits am Anschlussende angeordnet ist. Diese letzte Paarkontaktstelle kann entweder auch noch durch den ersten Routing-Kanal geroutet sein, oder direkt in den freien Leiterplattenbereich am Anschlussende. Bevorzugt ist diese letzte Paarkontaktstelle am Anschlussende nicht mehr durch den Routing-Kanal geroutet, um diesen nicht zu überfüllen. Hierbei wird ein besonders effizientes Routing für eine Mehrzahl von Differential-Pair-Signalen ermöglicht.

Erfindungsgemäß sind die Leiterbahnen zu den Einzelkontaktstellen der Mehrzahl von Paarkontaktstellen der ersten Gruppe in mehreren Ebenen, bevorzugt in zumindest drei Ebenen, übereinander durch den ersten Routing-Kanal geführt. Dies ist besonders platzsparend und reduziert die benötigte Breite des ersten Routing-Kanals (in Spaltenrichtung) zwischen der ersten und zweiten Reihe von Paarkontaktstellen.

Gemäß einer Weiterbildung ist zwischen den Ebenen, in denen die Leiterbahnen zu den beiden Einzelkontaktstellen der unterschiedlichen Paarkontaktstellen der ersten Gruppe übereinander durch den ersten Routing-Kanal geführt sind, jeweils eine elektrische Schirmung ausgebildet. Die elektrische Schirmung reduziert eine Beeinflussung der Differential-Pair-Signale an den Paarkontaktstellen der ersten Gruppe untereinander, während sie entlang des ersten Routing-Kanals übertragen werden.

Gemäß einer Ausführungsform weist die Leiterplatte einen zweiten Routing-Kanal auf, durch welchen Leiterbahnen zu den (z.B. beiden) Einzelkontaktstellen zumindest einer der Paarkontaktstellen der zweiten Gruppe geführt sind, wobei der zweite Routing-Kanal benachbart zur zweiten Reihe so angeordnet ist, dass er etwa parallel zu der ersten und zweiten Reihe angeordnet ist. Der zweite Routing-Kanal kann im Wesentlichen baugleich zum ersten Routing-Kanal ausgebildet sein, also insbesondere sämtliche (z.B. optionalen) Merkmale aufweisen, die auch der erste Routing-Kanal aufweisen kann. Der zweite Routing-Kanal kann z.B. zwischen der zweiten Reihe von Paarkontaktstellen und einer dritten Reihe von Paarkontaktstellen angeordnet sein. Der zweite Routing-Kanal kann zum Routen der Differential-Pair-Signale ausgebildet sein, die über die Paarkontaktstellen der zweiten Gruppe übertragen werden. So können die Differential-Pair-Signale jeder Gruppe von Paarkontaktstellen sicher auf der Leiterplatte geroutet werden.

Gemäß einer Ausführungsform weist die Leiterplatte eine vorbestimmte Reihenanzahl an Reihen von Paarkontaktstellen auf, welche etwa parallel zueinander auf der Leiterplatte angeordnet sind. Dabei ist jeder Reihe von Paarkontaktstellen genau ein Routing-Kanal zugeordnet, durch den Leiterbahnen zu sämtlichen Paarkontaktstellen der zugeordneten Reihe geführt sind, die nicht an einem Anschlussende dieser Reihe angeordnet sind. Diese Routing-Kanäle sind etwa parallel zu den Reihen von Paarkontaktstellen angeordnet. Die Reihen von Paarkontaktstellen und diese Routing-Kanäle sind jeweils alternierend nebeneinander angeordnet, wobei neben jeder Reihe von Paarkontaktstellen der jeweils zugeordnete Routing-Kanal ausgebildet ist. Hierbei kann die Reihenanzahl z.B. zumindest vier betragen, bevorzugt zumindest sechs oder zehn. Insbesondere kann die Reihenanzahl genau zwölf betragen. Die Routing-Kanäle und Reihen von Paarkontaktstellen sind hierbei abwechselnd nebeneinander in Spaltenrichtung auf der Leiterplatte angeordnet, ähnlich zu den dunklen und hellen Streifen eines Zebrastreifens. Dabei ist ein der ersten Reihe zugeordneter erster Routing-Kanal unmittelbar zwischen der ersten und zweiten Reihe von Paarkontaktstellen angeordnet, der der zweiten Reihe von Paarkontaktstellen zugeordnete zweite Routing-Kanal unmittelbar zwischen der zweiten und dritten Reihe von Paarkontaktstellen, usw. Sämtliche Reihen von Paarkontaktstellen und sämtliche dieser Routing-Kanäle können in Reihenrichtung etwa gleich lang ausgebildet sein und/oder bis zu einem Anschlussende reichen.

Gemäß einer Ausführungsform weist die Leiterplatte zumindest zehn Reihen von Paarkontaktstellen auf, denen jeweils zumindest ein Routing-Kanal zugeordnet ist. Im vorangegangenen Ausführungsbeispiel kann dies z.B. bedeuten, dass die vorbestimmte Reihenanzahl zumindest zehn beträgt. Hierbei können besonders viele Differential-Pair-Signale sicher geroutet werden.

Gemäß einer Ausführungsform weist jede Reihe von Paarkontaktstellen zumindest vier Paarkontaktstellen auf. Auch hierbei können besonders viele Differential-Pair-Signale sicher geroutet werden.

Gemäß einer Ausführungsform ist die Leiterplatte als die PCB-Karte ausgebildet, mit der das Verbindersystem den Zentralrechner des Kraftfahrzeugs verbindet, also z.B. als Bestandteil des Zentralrechners.

Gemäß einer alternativen Ausführungsform ist die Leiterplatte zum rechnerseitigen Kontaktieren des Verbindersystems ausgebildet.

Gemäß einer Ausführungsform weist die Leiterplatte neben den Reihen, in denen die Paarkontaktstellen ausgebildet sind, angeordnete Power-Kontaktstellen zum kartenseitigen und/oder rechnerseitigen Kontaktieren von Power-Kontaktelementen des Verbindersystems auf. Abhängig davon, ob die Leiterplatte zum kartenseitigen oder rechnerseitigen Kontaktieren des Verbindungssystems ausgebildet ist, sind auch die Power-Kontaktstellen zum entsprechenden Kontaktieren von Power-Kontaktelementen des Verbindersystems ausgebildet. Die Power-Kontaktstellen können z.B. in Spaltenrichtung benachbart zu den Paarkontaktstellen auf der Leiterplatte ausgebildet sein.

Gemäß einer Ausführungsform weist die Leiterplatte neben den Reihen, in denen die Paarkontaktstellen ausgebildet sind, angeordnete Single-End-Kontaktstellen zum kartenseitigen und/oder rechnerseitigen Kontaktieren von Single-End-Kontaktelementen des Verbindersystems auf. Abhängig davon, ob die Leiterplatte zum kartenseitigen oder rechnerseitigen Kontaktieren des Verbindungssystems ausgebildet ist, sind auch die Single-End-Kontaktstellen zum entsprechenden Kontaktieren von Single-End-Kontaktelementen des Verbindersystems ausgebildet. Die Single-End-Kontaktstellen können z.B. in Spaltenrichtung benachbart zu den Paarkontaktstellen auf der Leiterplatte ausgebildet sein.

In einer Weiterbildung zumindest einer der beiden vorangehenden Ausführungsformen sind die Power-Kontaktstellen und/oder die Single-End-Kontaktstellen in Reihen angeordnet, die etwa parallel zu den Reihen angeordnet sind, in denen die Paarkontaktstellen ausgebildet sind. Mit anderen Worten sind die Reihen von Power-Kontaktstellen und/oder Single-End-Kontaktstellen ebenfalls in Reihenrichtung hintereinander angeordnet. Dabei kann die Leiterplatte analog zu den Routing-Kanälen für die Paarkontaktstellen auch Power-Routing-Kanäle und/oder Single-End-Routing-Kanäle aufweisen, die jeweils benachbart und parallel zu einer zugeordneten Reihe von Power-Kontaktstellen und/oder Single-End-Kontaktstellen angeordnet sind. Diese Power-Routing-Kanäle und/oder Single-End-Routing-Kanäle können analog zu den Routing-Kanälen für die Paarkontaktstellen ausgebildet sein, und insbesondere auch die optionalen Merkmale dieser Routing-Kanäle aufweisen.

Ein Aspekt betrifft ein Verbindersystem zum Verbinden einer PCB-Karte mit einem Zentralrechner eines Kraftfahrzeugs, aufweisend ein rechnerseitiges Verbinderelement mit einer Mehrzahl von rechnerseitigen Differential-Pair-Kontaktelementen und ein kartenseitiges Verbinderelement mit einer Mehrzahl von kartenseitigen Differential-Pair-Kontaktelementen, mit zumindest einer Leiterplatte nach dem voranstehenden Aspekt zum kartenseitigen und/oder rechnerseitigen Kontaktieren der kartenseitigen und/oder rechnerseitigen Differential-Pair-Kontaktelemente. Einzelheiten des kartenseitigen und rechnerseitigen Verbinderelements sind nachfolgend näher beschrieben.

Gemäß einer Ausführungsform kontaktieren die rechnerseitigen Differential-Pair-Kontaktelemente des rechnerseitigen Verbinderelements eine erste Leiterplatte gemäß dem voranstehenden Aspekt und die kartenseitigen Differential-Pair-Kontaktelemente des kartenseitigen Verbinderelements eine zweite Leiterplatte gemäß dem voranstehenden Aspekt als die PCB-Karte.

Gemäß einer Ausführungsform weist das rechnerseitige Verbinderelement auf:
- ein rechnerseitiges Zinkdruckguss-Gehäuse mit zumindest einem rechnerseitigen Kontakthohlraum;
- zumindest einen rechnerseitigen Isolierkörper, welcher im montierten Zustand innerhalb des zumindest einen rechnerseitigen Kontakthohlrraums angeordnet ist; und
- eine Mehrzahl von rechnerseitigen Kontaktelementen, welche im montierten Zustand zumindest bereichsweise innerhalb von rechnerseitigen Isolierhohlräumen in dem zumindest einen rechnerseitigen Isolierkörper angeordnet sind.

Dabei weist das kartenseitige Verbinderelement auf:
- ein kartenseitiges Zinkdruckguss-Gehäuse mit zumindest einem kartenseitigen Kontakthohlraum;
- zumindest einen kartenseitigen Isolierkörper, welcher im montierten Zustand innerhalb des zumindest einen kartenseitigen Kontakthohlraums angeordnet ist und eine Mehrzahl kartenseitige Isolierhohlräume aufweist, die ausgelegt sind, um im montierten Zustand die rechnerseitigen Kontaktelemente zumindest bereichsweise aufzunehmen; und
- eine Mehrzahl von kartenseitigen Kontaktelementen, welche im montierten Zustand zumindest bereichsweise innerhalb der kartenseitigen Isolierhohlräume angeordnet sind und die rechnerseitigen Kontaktelemente elektrisch kontaktieren.

Unter dem Begriff "Verbinden" wird im Rahmen dieser Beschreibung insbesondere ein elektrisches Verbinden verstanden. Dabei kann zusätzlich auch ein physikalisches Verbinden darunter verstanden werden. Unter einem "rechnerseitigen Verbinderelement" wird ein Verbinderelement verstanden, welches ausgelegt ist, um (elektrisch und/oder physikalisch) unmittelbar an einen Zentralrechner angeschlossen zu werden. Entsprechend wird unter einem "kartenseitigen Verbinderelement" ein Verbinderelement verstanden, welches ausgelegt ist, um (elektrisch und/oder physikalisch) unmittelbar an eine PCB-Karte angeschlossen zu werden. Allgemein deutet die Zusatzbezeichnung "rechnerseitig" bei verschiedenen Elementen an, dass diese rechnerseitigen Elemente zu dem rechnerseitigen Verbinderelement gehören und/oder Bestandteil davon sind. Entsprechend deutet die Zusatzbezeichnung "kartenseitig" bei verschiedenen Elementen an, dass diese kartenseitigen Elemente zu dem kartenseitigen Verbinderelement gehören und/oder Bestandteil davon sind.

Der montierte Zustand des Verbindersystems bezeichnet im Sinne der vorliegenden Beschreibung einen Zustand, in dem das Verbindersystem, das rechnerseitige Verbinderelement und/oder das kartenseitige Verbinderelement bestimmungsgemäß verwendet wird und/oder bestimmungsgemäß montiert, zusammengesetzt oder zusammengesteckt ist. Insbesondere bezeichnet der montierte Zustand, dass das rechnerseitige und kartenseitige Verbinderelement miteinander elektrisch verbunden sind. Der montierte Zustand kann daher auch als zusammengebauter Zustand, zusammengesetzter Zustand, zusammengesteckter Zustand und/oder als Betriebszustand bezeichnet sein. Mit anderen Worten bezeichnet der montierte Zustand eines Verbinderelements bzw. Verbindersystems eine bestimmungsgemäße Anordnung oder Einbauposition der einzelnen Elemente des Verbinderelements und/oder Verbindersystems.

Die PCB-Karte kann insbesondere als eine PCMCIA Express 3.0 und/oder 4.0 Karte ausgebildet sein. Der Begriff "PCB-Karte" kann auch andere Chipkarten betreffen, welche grundsätzlich für die Verwendung im Automotive Bereich geeignet sind.

Das rechnerseitige Verbinderelement weist ein rechnerseitiges Zinkdruckguss-Gehäuse auf. Das rechnerseitige Zinkdruckguss-Gehäuse weist zumindest einen rechnerseitigen Kontakthohlraum auf, bevorzugt eine Mehrzahl von rechnerseitigen Kontakthohlräumen. Der (oder die) rechnerseitige(n) Kontakthohlraum(-räume) sind als Aussparungen im Zinkdruckguss-Gehäuse ausgebildet. Jeder rechnerseitige Kontakthohlraum bildet eine rechnerseitige Kontaktöffnung aus. Mit anderen Worten ist das rechnerseitige Zinkdruckguss-Gehäuse, insbesondere einstückig, aus Zinkdruckguss ausgebildet und/oder gefertigt. Vorzugsweise ist das Zinkdruckguss-Material aus einer Zink-Legierung ausgebildet, insbesondere der Legierung ZP0410, ZP0400 und/oder ZP0430. Diese Legierungen sind z.B. aus der Norm EN 12844 bekannt und dort beschrieben. Alternativ kann das rechnerseitige Zinkdruckguss-Gehäuse aus einem anderen Zinkdruckguss-Material ausgebildet sein. Insbesondere ist das rechnerseitige Zinkdruckguss-Gehäuse einstückig ausgebildet, d.h. es ist nicht aus mehreren Teilen zusammengesetzt, sondern umfasst lediglich ein einziges Teil aus einem Zinndruckguss-Material. Weist das rechnerseitige Gehäuse eine Mehrzahl von rechnerseitigen Kontakthohlräumen auf, so können diese im rechnerseitigen Gehäuse zumindest bereichsweise in Form einer Matrix angeordnet sein. Das rechnerseitige Zinkdruckguss-Gehäuse kann eine Schirmwirkung aufweisen und eine hohe Signalqualität bewirken.

Das rechnerseitige Verbinderelement weist den zumindest einen rechnerseitigen Isolierkörper auf. Dabei kann das rechnerseitige Verbinderelement auch eine Mehrzahl von rechnerseitigen Isolierkörpern aufweisen. Der oder die rechnerseitigen Isolierkörper weisen eine Mehrzahl rechnerseitige Isolierhohlräume auf. Dabei kann einer der rechnerseitigen Isolierkörper entweder eine Mehrzahl der rechnerseitigen Isolierhohlräume aufweisen, oder genau einen der rechnerseitigen Isolierhohlräume. Dies bedeutet für einen Extremfall, in dem das rechnerseitige Verbinderelement genau einen rechnerseitigen Isolierkörper aufweist, dass dieser eine rechnerseitige Isolierkörper alle rechnerseitigen Isolierhohlräume aufweist. Es bedeutet für einen anderen Extremfall, in dem das rechnerseitige Verbinderelement genau so viele rechnerseitige Isolierkörper aufweist wie rechnerseitige Isolierhohlräume, dass jeder rechnerseitige Isolierkörper genau einen rechnerseitigen Isolierhohlraum aufweist. Dazwischen gibt es Ausführungsformen, bei denen z.B. eine Gruppe an rechnerseitigen Isolierkörpern jeweils genau einen rechnerseitigen Isolierhohlraum aufweist, und einer (oder mehrere) weitere(r) rechnerseitige(r) Isolierkörper(n) jeweils mehrere rechnerseitige Isolierhohlräume.

Der oder die rechnerseitige(n) Isolierhohlraum(-räume) ist bzw. sind im montierten Zustand innerhalb des bzw. der rechnerseitigen Kontakthohlraums(-räume) angeordnet. Vorzugsweise ist der zumindest eine rechnerseitige Isolierkörper aus den Materialien PA9T, PA10T und/oder LCP ausgebildet und/oder gefertigt. Die Anzahl der rechnerseitigen Isolierkörper kann z.B. der Anzahl an rechnerseitigen Kontakthohlräumen entsprechen. Die rechnerseitigen Isolierkörper können z.B. etwa rechteckförmig ausgebildet sein, wodurch eine einfache Montage ermöglicht wird.

Zusätzlich weist das rechnerseitige Verbinderelement eine Mehrzahl von rechnerseitigen Kontaktelementen, insbesondere Kontaktstifte, auf. Diese beinhalten die rechnerseitigen Differential-Pair-Kontaktelemente zum rechnerseitigen Kontaktieren der Paarkontaktstellen der rechnerseitig angeordneten Leiterplatte. Vorzugsweise sind die rechnerseitigen Kontaktelemente aus CuSn6 oder alternativen Kupferlegierungen ausgebildet und/oder gefertigt. Allgemein sind Kontaktelemente elektrische Leiter, mit denen elektrische Signale übertragen werden können. Die rechnerseitigen Kontaktelemente sind im montierten Zustand zumindest bereichsweise innerhalb der rechnerseitigen Isolierhohlräume des zumindest einen rechnerseitigen Isolierkörpers angeordndet, und damit auch innerhalb des zumindest einen rechnerseitigen Kontakthohlraums. Mit anderen Worten umgibt der zumindest eine rechnerseitige Isolierkörper die rechnerseitigen Kontaktelemente zumindest bereichsweise. "Zumindest bereichsweise" bedeutet in diesem Zusammenhang, dass jeweils zumindest ein Abschnitt eines rechnerseitigen Kontaktelements innerhalb eines rechnerseitigen Isolierhohlraums des zumindest einen rechnerseitigen Isolierkörpers angeordnet ist und/oder dass einer der rechnerseitigen Isolierkörper zumindest einen Abschnitt jedes rechnerseitigen Kontaktelements umgibt. Insbesondere sind die rechnerseitigen Kontaktelemente im montierten Zustand zumindest bereichsweise innerhalb von rechnerseitigen Isolierhohlräumen des zumindest einen rechnerseitigen Isolierkörpers angeordnet, so dass sie gegenüber dem rechnerseitigen Gehäuse elektrisch isoliert sind. Die rechnerseitigen Kontaktelemente können das rechnerseitige Gehäuse im Wesentlichen vollständig durchdringen.

Abgesehen von der isolierenden Wirkung ist der zumindest eine rechnerseitige Isolierkörper auch dazu ausgebildet, die rechnerseitigen Kontaktelemente in dem zumindest einen rechnerseitigen Kontakthohlraum zu halten und/oder zu befestigen. Der zumindest eine Isolierkörper kann somit neben seiner Isolierfunktion auch eine Stabilitätsfunktion aufweisen, d.h. eine Halte- und/oder Befestigungsfunktion. An den Stellen bzw. Abschnitten der Kontaktelemente, die nicht von einem Isolierkörper umgeben sind, kann Luft als Isolator verwendet werden.

Ein Steckende der rechnerseitigen Kontaktelemente kann aus dem rechnerseitigen Gehäuse herausragen und zum Kontaktieren des Zentralrechners ausgebildet sein. Hierbei können die Steckenden der rechnerseitigen Kontaktelemente insbesondere zum Kontaktieren der Leiterplatte gemäß dem voranstehenden Aspekt ausgebildet sein.

Das kartenseitige Verbinderelement weist ein kartenseitiges Zinkdruckguss-Gehäuse auf. Das kartenseitige Zinkdruckguss-Gehäuse weist zumindest einen kartenseitigen Kontakthohlraum auf, bevorzugt eine Mehrzahl von kartenseitigen Kontakthohlräumen. Der (oder die) kartenseitige(n) Kontakthohlraum(-räume) sind als Aussparung im Zinkdruckguss-Gehäuse ausgebildet. Jeder kartenseitige Kontakthohlraum bildet eine kartenseitige Kontaktöffnung aus.

Das kartenseitige Zinkdruckguss-Gehäuse kann zweistückig ausgebildet sein, d.h. es kann aus genau zwei Teilen aus Zinkdruckguss, nämlich einem ersten kartenseitigen Zinkdruckguss-Gehäuse und einem zweiten kartenseitigen Zinkdruckguss-Gehäuse, zusammengesetzt sein. Alternativ kann auch das kartenseitige Zinkdruckguss-Gehäuse einstückig ausgebildet sein. Vorzugsweise ist das Zinkdruckguss-Material aus einer Zink-Legierung ausgebildet, insbesondere der Legierung ZP0410, ZP0400 und/oder ZP0430. Diese Legierungen sind z.B. aus der Norm EN 12844 bekannt und dort beschrieben. Alternativ kann das kartenseitige Zinkdruckguss-Gehäuse aus einem anderen Zinkdruckguss-Material ausgebildet sein. Das kartenseitige Zinkdruckguss-Gehäuse kann eine (elektrische) Schirmwirkung aufweisen und eine hohe Signalqualität ermöglichen.

Weist das kartenseitigen Gehäuse eine Mehrzahl von kartenseitigen Kontakthohlräumen auf, so können diese im kartenseitigen Gehäuse zumindest bereichsweise in Form einer Matrix angeordnet sein, insbesondere (zumindest bereichsweise) komplementär zu den rechnerseitigen Kontakthohlräumen. Allgemein kann für jeden rechnerseitigen Kontakthohlraum ein zugehöriger bzw. komplementärer kartenseitiger Kontakthohlraum vorgesehen und/oder ausgebildet sein.

Das kartenseitige Verbinderelement weist den zumindest einen kartenseitigen Isolierkörper auf. Dabei kann das kartenseitige Verbinderelement auch eine Mehrzahl von kartenseitigen Isolierkörpern aufweisen. Der oder die kartenseitigen Isolierkörper weisen eine Mehrzahl kartenseitige Isolierhohlräume auf. Dabei kann einer der kartenseitigen Isolierkörper entweder eine Mehrzahl der kartenseitigen Isolierhohlräume aufweisen, oder genau einen der kartenseitigen Isolierhohlräume. Dies bedeutet für einen Extremfall, in dem das kartenseitige Verbinderelement genau einen kartenseitigen Isolierkörper aufweist, dass dieser eine kartenseitige Isolierkörper alle kartenseitigen Isolierhohlräume aufweist. Es bedeutet für einen anderen Extremfall, in dem das kartenseitige Verbinderelement genau so viele kartenseitige Isolierkörper aufweist wie kartenseitige Isolierhohlräume, dass jeder kartenseitige Isolierkörper genau einen kartenseitigen Isolierhohlraum aufweist. Dazwischen gibt es Ausführungsformen, bei denen z.B. eine Gruppe an kartenseitigen Isolierkörpern jeweils genau einen kartenseitigen Isolierhohlraum aufweist, und einer (oder mehrere) weitere(r) kartenseitige(r) Isolierkörper(n) jeweils mehrere kartenseitige Isolierhohlräume.

Der oder die kartenseitige(n) Isolierhohlraum(-räume) ist bzw. sind im montierten Zustand innerhalb des bzw. der kartenseitigen Kontakthohlraums(-räume) angeordnet. Vorzugsweise ist der zumindest eine kartenseitige Isolierkörper aus den Materialien PA9T, PA10T und/oder LCP ausgebildet und/oder gefertigt. Die Anzahl der kartenseitigen Isolierkörper kann z.B. der Anzahl an kartenseitigen Kontakthohlräumen entsprechen. Die kartenseitigen Isolierkörper können z.B. bereichsweise rechteckförmig ausgebildet sein, wodurch eine einfache Montage ermöglicht werden kann.

Der oder die kartenseitigen Isolierkörper weisen kartenseitige Isolierhohlräume auf, die ausgelegt sind, um im montierten Zustand die rechnerseitigen Kontaktelemente zumindest bereichsweise aufzunehmen. Mit anderen Worten dringen im montierten Zustand die rechnerseitigen Kontaktelemente in den zumindest einen kartenseitigen Isolierkörper ein, um die kartenseitigen Kontaktelemente zu kontaktieren. Die Anzahl der kartenseitigen Isolierkörper kann der Anzahl von kartenseitigen Kontakthohlräumen entsprechen. Weiter kann die Anzahl von rechnerseitigen Kontakthohlräumen der Anzahl von kartenseitigen Kontakthohlräumen entsprechen.

Zusätzlich weist das kartenseitige Verbinderelement eine Mehrzahl von kartenseitigen Kontaktelementen auf. Diese beinhalten die kartenseitigen Differential-Pair-Kontaktelemente zum kartenseitigen Kontaktieren der Paarkontaktstellen der kartenseitig angeordneten Leiterplatte. Vorzugsweise sind die kartenseitigen Kontaktelemente aus CuSn6 oder alternativen Kupferlegierungen ausgebildet bzw. gefertigt. Die kartenseitigen Kontaktelemente sind im montierten Zustand zumindest bereichsweise innerhalb von den kartenseitigen Isolierhohlräumen des zumindest einen kartenseitigen Isolierkörpers angeordnet, und damit auch innerhalb des zumindest einen kartenseitigen Kontakthohlraums. Mit anderen Worten umgibt der zumindest eine kartenseitige Isolierkörper die kartenseitigen Kontaktelemente zumindest bereichsweise. Der Begriff "zumindest bereichsweise" bedeutet in diesem Zusammenhang, dass jeweils zumindest ein Abschnitt eines kartenseitigen Kontaktelements innerhalb eines kartenseitigen Isolierhohlraums eines kartenseitigen Isolierkörpers angeordnet ist und/oder dass ein kartenseitiger Isolierkörper zumindest einen Abschnitt eines kartenseitigen Kontaktelements umgibt. Insbesondere sind die kartenseitigen Kontaktelemente im montierten Zustand zumindest bereichsweise innerhalb von kartenseitigen Isolierhohlräumen des zumindest einen kartenseitigen Isolierkörpers angeordnet, so dass sie gegenüber dem kartenseitigen Gehäuse elektrisch isoliert sind. Die kartenseitigen Kontaktelemente sind derart ausgelegt und angeordnet, dass sie im montierten Zustand jeweils zugehörige rechnerseitige Kontaktelemente kontaktieren. Die Kontaktierung der rechnerseitigen und kartenseitigen Kontaktelemente erfolgt insbesondere innerhalb der kartenseitigen Kontakthohlräume und/oder innerhalb der kartenseitigen Isolierkörper. Alternativ kann die Kontaktierung der rechnerseitigen und kartenseitigen Kontaktelemente innerhalb der rechnerseitigen Kontakthohlräume und/oder innerhalb der rechnerseitigen Isolierkörper erfolgen.

Ein Steckende der kartenseitigen Kontaktelemente kann aus dem kartenseitigen Gehäuse herausragen und zum Kontaktieren der PCB-Karte ausgebildet sein, welche als die Leiterplatte gemäß dem ersten Aspekt ausgebildet sein kann.

Abgesehen von der isolierenden Wirkung kann der zumindest eine kartenseitige Isolierkörper dazu ausgebildet sein, die kartenseitigen Kontaktelemente in dem zumindest einen kartenseitigen Kontakthohlraum zu halten und/oder zu befestigen. Der zumindest eine kartenseitige Isolierkörper kann sowohl eine Isolierfunktion als auch eine Stabilitätsfunktion aufweisen und/oder erfüllen. An den Stellen bzw. Abschnitten der kartenseitigen Kontaktelemente, die nicht von einem kartenseitigen Isolierkörper umgeben sind, kann Luft als Isolator verwendet werden.

Bei dem Verbindersystem weist das rechnerseitige Verbinderelement und/oder das kartenseitige Verbinderelement jeweils ein Zinkdruckguss-Gehäuse mit jeweils zumindest einem Kontakthohlraum auf. Dadurch kann im montierten Zustand eine durchgängige Abschirmwirkung auf Grund der von den Zinkdruckguss-Gehäusen umgebenenen Hohlräumen erzielt werden, in welchen sich die signalübertragenden Kontaktelemente befinden. Es hat sich gezeigt, dass das Verbindersystem den eingangs aufgeführten Anforderungen im Automotive Bereich genügen. Zudem können die Verbinderelemente und somit das Verbindersystem schnell und einfach im Zinkdruckguss hergestellt werden, so dass sie im Vergleich zu herkömmlichen Verbindern, die den Anforderungen im Automotive Bereich genügen, auch massentauglich sind. Durch die Ausbildung der Gehäuse im Zinkdruckguss kann sowohl eine elektrische Abschirmung, eine massentaugliche Herstellung und eine vibrationsbeständige Festigkeit erreicht werden.

Ein Aspekt betrifft ein Verfahren zum Herstellen einer Leiterplatte zum kartenseitigen und/oder rechnerseitigen Kontaktieren eines Verbindersystems, wobei das Verbindersystem zum Verbinden einer PCB-Karte mit einem Zentralrechner eines Kraftfahrzeugs ausgebildet ist, und wobei durch das Verbindersystem Differential-Pair-Signale entlang von Differential-Pair-Kontaktelementen des Verbindersystems leitbar sind, mit den Schritten:
- Ausbilden einer Mehrzahl von Paarkontaktstellen zum Kontaktieren von Differential-Pair-Kontaktelementen des Verbindersystems, wobei jede Paarkontaktstelle zwei Einzelkontaktstellen zum Kontaktieren von einzelnen Kontaktelementen des jeweiligen Differential-Pair-Kontaktelements des Verbindersystems aufweist,
- Ausbilden zumindest eines ersten Routing-Kanals, durch welchen Leiterbahnen zu den Einzelkontaktstellen zumindest einer der Paarkontaktstellen geführt sind;
wobei
- eine erste Gruppe der Paarkontaktstellen hintereinander in einer ersten Reihe auf der Leiterplatte angeordnet wird,
- eine zweite Gruppe der Paarkontaktstellen hintereinander in einer zweiten Reihe auf der Leiterplatte angeordnet wird, wobei die zweite Reihe etwa parallel zu der ersten Reihe angeordnet wird,
- durch den ersten Routing-Kanal Leiterbahnen zu den beiden Einzelkontaktstellen zumindest einer der Paarkontaktstellen der ersten Gruppe geführt werden, und
- der erste Routing-Kanal zwischen der ersten Reihe und der zweiten Reihe so angeordnet wird, dass er etwa parallel zu der ersten und zweiten Reihe angeordnet wird.

Das Verfahren kann insbesondere zum Herstellen einer Leiterplatte gemäß des eingangs beschriebenen Aspekts verwendet werden. Deswegen betreffen sämtliche Ausführungen zu der Leiterplatte auch das Verfahren und umgekehrt.

Im Rahmen dieser Erfindung können die Begriffe "im Wesentlichen" und/oder "etwa" so verwendet sein, dass sie eine Abweichung von bis zu 5% von einem auf den Begriff folgenden Zahlenwert beinhalten, eine Abweichung von bis zu 5° von einer auf den Begriff folgenden Richtung und/oder von einem auf den Begriff folgenden Winkel.

Begriffe wie oben, unten, oberhalb, unterhalb, usw. beziehen sich -sofern nicht anders spezifiziert- auf das Bezugssystem der Erde in einer Betriebsposition des Gegenstands der Erfindung.

Im Folgenden werden einzelne Ausführungsformen zur Lösung der Aufgabe anhand der Figuren beispielhaft beschrieben. Hierbei können gleiche oder ähnliche Bezugszeichen gleiche oder ähnliche Merkmale der Ausführungsformen kennzeichnen. Einzelne in den Figuren gezeigte Merkmale können in anderen Ausführungsbeispielen implementiert sein. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.
- Figur 1: zeigt einen schematisch dargestellte Ansicht eines Bereichs einer Leiterplatte zum Kontaktieren des in den Figuren 2 bis 4 dargestellten Verbindersystems;
- Figur 2: zeigt in einer perspektivischen Explosionsansicht eine schematische Skizze eines Verbindersystems ohne Leiterplatte;
- Figur 3A: zeigt in einer ersten perspektivischen Ansicht (Vorderansicht) eine schematische Skizze des rechnerseitigen Gehäuses des Verbindersystems aus Figur 2;
- Figur 3B: zeigt in einer zweiten perspektivischen Ansicht (Rückansicht) eine schematische Skizze des rechnerseitigen Gehäuses des Verbindersystems aus Figur 2;
- Figur 4: zeigt in der perspektivischen Ansicht aus Figur 3A (Vorderansicht) eine schematische Skizze des rechnerseitigen Verbinderelements des Verbindersystems aus Figur 2 ohne das rechnerseitige Gehäuse; und
- Figur 5: zeigt das Layout einer Leiterplatte zum Kontaktieren des rechnerseitigen Verbinderelements des Verbindungssystems.

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen. Die Zusatzbezeichnung "rechnerseitig", wie sie in der vorliegenden Beschreibung für verschiedene Elemente verwendet wird, bedeutet, dass diese Elemente zu dem rechnerseitigen Verbinderelement, d.h. einem Verbinderelement, welches unmittelbar mit dem Zentralrechner verbunden werden kann, gehören und/oder zur Verbindung mit diesem ausgebildet sind. Entsprechend bedeutet die Zusatzbezeichnung "kartenseitig" bei verschiedenen Elementen an, dass diese Elemente zu dem kartenseitigen Verbinderelement gehören, d.h. einem Verbinderelement, welches unmittelbar mit einer PCB-Karte verbunden werden kann, und/oder zur Verbindung mit diesem ausgebildet sind.

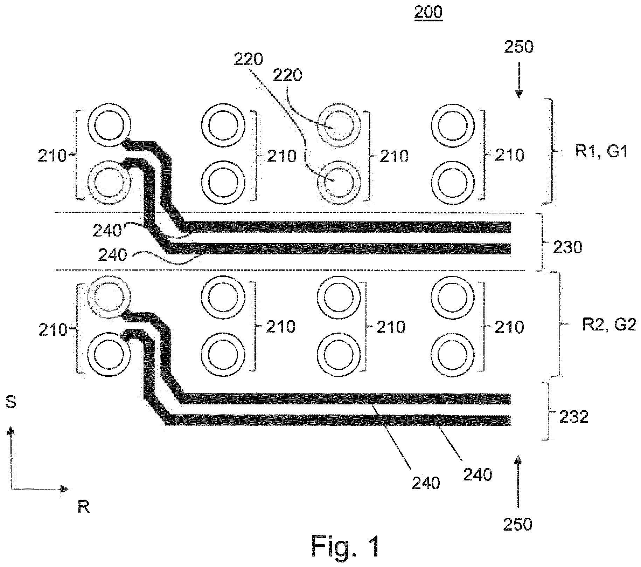

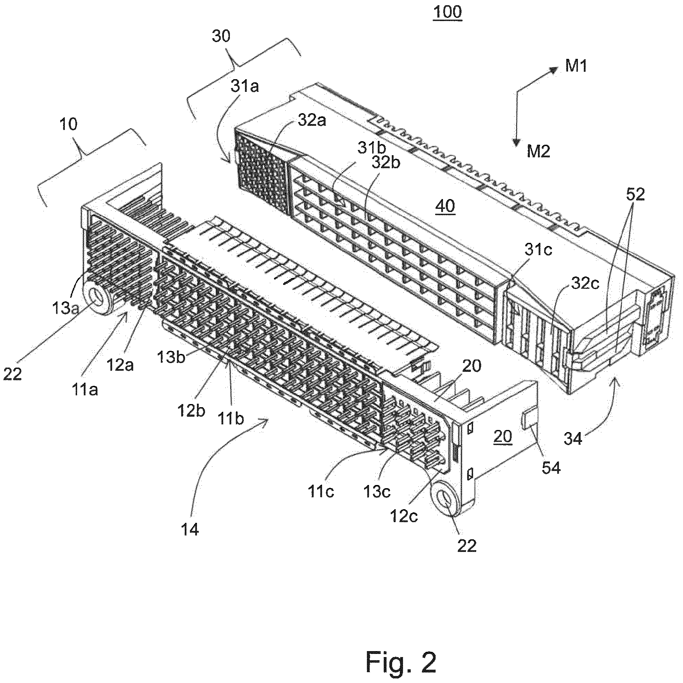

Die **Figur 1** zeigt eine schematisch dargestellte Ansicht eines Bereichs einer Leiterplatte 200 zum elektrischen Kontaktieren des in den nachfolgenden Figuren 2 bis 4 dargestellten Verbindersystems 100.

Figur 1 zeigt einen Bereich der Leiterplatte 200, der zum Kontaktieren von rechnerseitigen und/oder kartenseitigen Differential-Pair-Kontaktelementen 13b und/oder 33b des Verbindersystems 100 ausgebildet ist, die mit Bezug auf die nachfolgenden Figuren 2 bis 4 näher beschrieben sind.

Dazu weist die Leiterplatte 200 mehrere Paarkontaktstellen 210 auf, die zum Bonden mit den rechnerseitigen und/oder kartenseitigen Differential-Pair-Kontaktelementen 13b und/oder 33b des Verbindersystems 100 ausgebildet sind. Hierbei weist jede Paarkontaktstelle 210 genau zwei Einzelkontaktstellen 220 auf, von denen in Figur 1 nur exemplarisch zwei gekennzeichnet sind. Die Einzelkontaktstellen 220 können jeweils genau eine Aufnahme (wie z.B. ein Bohrloch) für ein Steckende der rechnerseitigen und/oder kartenseitigen Differential-Pair-Kontaktelement 13b und/oder 33b des Verbindersystems 100 aufweisen.

Die beiden Einzelkontaktstellen 220 jeder Paarkontaktstelle 210 können in Spaltenrichtung S voneinander beabstandet auf der Leiterplatte 200 angeordnet sein. Hierbei können die beiden Einzelkontaktstellen 220 jeder Paarkontaktstelle 210 unmittelbar zueinander benachbart auf der Leiterplatte 200 ausgebildet sein, d.h. dass kein weiteres Element der Leiterplatte 200 zwischen ebendiesen Einzelkontaktstellen 220 ausgebildet ist (außer dem Leiterplattenmaterial der Leiterplatte 200 selber).

Die Paarkontaktstellen 210 der Leiterplatte 200 sind in Gruppen aufgeteilt. In dem in Figur 1 gezeigten Ausschnitt sind eine erste Gruppe G1 von Paarkontaktstellen 210 und eine zweite Gruppe G2 von Paarkontaktstellen 210 gezeigt. Hierbei weist jede Gruppe von Paarkontaktstellen 210 die gleiche, vorbestimmte Anzahl von Paarkontaktstellen 210 auf. Im gezeigten Ausführungsbeispiel weist jede Gruppe von Paarkontaktstellen 210 genau vier Paarkontaktstellen 210 auf.

Sämtliche Paarkontaktstellen 210 jeder Gruppe sind in Reihe hintereinander angeordnet. So sind die vier Paarkontaktstellen 210 der ersten Gruppe G1 hintereinander in einer ersten Reihe R1 angeordnet, und die vier Paarkontaktstellen 210 der zweiten Gruppe G2 hintereinander in einer zweiten Reihe R2 angeordnet. Dabei erstrecken sich die beiden Reihen R1 und R2 etwa parallel zueinander in eine Reihenrichtung R.

Die Spaltenrichtung S und die Reihenrichtung R sind etwa senkrecht zueinander und in der Erstreckungsebene der Leiterplatte 200 angeordnet.

Hierbei können sämtliche Reihen von Paarkontaktstellen 210 etwa gleich lang ausgebildet sein, die gleiche vorbestimmte Paarkontaktanzahl an Paarkontaktstellen 210 aufweisen (im gezeigten Ausführungsbeispiel vier), und/oder jeweils in Spaltenrichtung S voneinander beabstandet angeordnet sein. Weiterhin können sie auf gleicher Höhe nebeneinander auf der Leiterplatte 200 angeordnet sein, so dass jeweils zwei Paarkontaktstellen 210 benachbarter Reihen in Spaltenrichtung S hintereinander angeordnet sind und sozusagen Spalten ausbilden.

Diese Spalten von Paarkontaktstellen 210 sind unterbrochen von Routing-Kanälen 230, 232, die zwischen den Reihen R1, R2 angeordnet sind.

Die Reihen von Paarkontaktstellen 210 enden allesamt an einem Anschlussende 250. So erstrecken sich die erste Reihe R1 und die zweite Reihe R2 von dem Anschlussende 250 weg gegen die Reihenrichtung R entlang der Oberfläche der Leiterplatte 200. Das Anschlussende 250 kann an einen freien Leiterplattenbereich der Leiterplatte 200 angrenzen. An diesem freien Leiterplattenbereich wird kein Kontaktelement des Verbindersystems 100 mehr kontaktiert, so dass in diesem freien Leiterplattenbereich mehr Platz zum Routen der Differential-Pair-Signale zur Verfügung steht als zwischen den einzelnen Paarkontaktstellen 210. Deswegen ist ein Routing in diesem angrenzenden freien Leiterplattenbereich nicht mehr in Figur 1 gezeigt, sondern kann dort herkömmlich und/oder anwendungsspezifisch ausgebildet sein.

Im gezeigten Ausschnitt der Leiterplatte 200 ist ein erster Routing-Kanal 230 zwischen der ersten Reihe R1 und der zweiten Reihe R2 von Paarkontaktstellen 210 angeordnet. Weiterhin ist ein zweiter Routing-Kanal 232 auf der dem ersten Routing-Kanal 230 abgewandten Seite der zweiten Reihe R2 angeordnet. Der zweite Routing-Kanal 232 kann z.B. zwischen der zweiten Reihe R2 und einer weiteren, nicht mehr in Figur 1 gezeigten, dritten Reihe von Paarkontaktstellen 210 ausgebildet sein.

Der erste Routing-Kanal 230 ist zum Routen von Leiterbahnen 240 ausgebildet, die Differential-Pair-Signale von und/oder zu den Einzelkontakten 220 einer Paarkontaktstelle 210 der ersten Reihe R1 übertragen können. In Figur 1 sind lediglich zwei Leiterbahnen 240 durch den ersten Routing-Kanal 230 gezeigt, die zu den Einzelkontakten 220 derjenigen Paarkontaktstelle 210 führen, die am weitesten vom Anschlussende 250 entfernt angeordnet ist. Diese beiden Leiterbahnen 240 sind in derselben Ebene angeordnet.

In Figur 1 ist nicht mehr gezeigt, dass auch Leiterbahnen 240 zu den beiden mittleren Paarkontaktstellen 210 der ersten Reihe R1 durch den ersten Routing-Kanal 230 geführt sind. Diese Leiterbahnen zu den beiden mittleren Paarkontaktstellen 210 sind jeweils in einer anderen Ebene durch den ersten Routing-Kanal 230 geführt, z.B. durch eine Schirmung voneinander getrennt.

Allgemein können durch den ersten Routing-Kanal 230 Leiterbahnen 240 zu sämtlichen Einzelkontakten 220 der Paarkontaktstellen 210 der ersten Reihe R1 geführt sein, die nicht unmittelbar am Anschlussende 250 ausgebildet sind. Die unmittelbar am Anschlussende 250 angeordnete Paarkontaktstelle 210 kann auch außerhalb des ersten Routing-Kanals 230 in den angrenzenden freien Leiterplattenbereich geroutet sein.

Genauso ist der zweite Routing-Kanal 232 zum Routen von Leiterbahnen 240 ausgebildet, die Differential-Pair-Signale von und/oder zu den Einzelkontakten 220 einer Paarkontaktstelle 210 der zweiten Reihe R2 übertragen können. In Figur 1 sind lediglich zwei Leiterbahnen 240 durch den zweiten Routing-Kanal 232 gezeigt, die zu den Einzelkontakten 220 derjenigen Paarkontaktstelle 210 führen, die am weitesten vom Anschlussende 250 entfernt angeordnet ist. Diese beiden Leiterbahnen 240 sind in derselben Ebene angeordnet.

In Figur 1 ist nicht mehr gezeigt, dass auch Leiterbahnen 240 zu den beiden mittleren Paarkontaktstellen 210 der zweiten Reihe R2 durch den zweiten Routing-Kanal 232 geführt sind. Diese Leiterbahnen zu den beiden mittleren Paarkontaktstellen 210 können jeweils in einer anderen Ebene durch den zweiten Routing-Kanal 232 geführt sein, z.B. getrennt voneinander durch eine Schirmung.

Genauso wie beim ersten Routing-Kanal 230 können auch durch den zweiten Routing-Kanal 232 Leiterbahnen 240 zu sämtlichen Einzelkontakten 220 der Paarkontaktstelle 210 der zweiten Reihe R2 geführt sein, die nicht unmittelbar am Anschlussende 250 ausgebildet sind.

Gleiches gilt für nicht in Figur 1 gezeigte weitere Routing-Kanäle zum elektrischen Kontaktieren von weiteren, nicht in Fig. 1 gezeigten Reihen von Paarkontaktstellen 210.

Die Routing-Kanäle 230, 232 erstrecken sich von einem dem Anschlussende 250 abgewandten Reihenende der Reihen R1, R2 von Paarkontaktstellen 210 bis zum Anschlussende 250 im Wesentlichen geradlinig.

Dabei können sämtliche Routing-Kanäle und Reihen von Paarkontaktstellen 210 etwa parallel zueinander in Reihenrichtung R ausgerichtet sein, und jeweils so abwechselnd alternierend in Spaltenrichtung S angeordnet, dass der einer Reihe zugeordnete Routing-Kanal benachbart zur zugeordneten Reihe angeordnet ist.

Die Anordnung der Routing-Kanäle und Paarkontaktstellen 210 auf der Leiterplatte ist auf die Anordnung der rechnerseitigen und/oder kartenseitigen Differential-Pair-Kontaktelemete 13b, 33b des Verbindersystems 100 abgestimmt, das nachfolgend näher beschrieben ist.

Die **Figur 2** zeigt in einer perspektivischen Explosionsansicht eine schematische Skizze eines Verbindersystems 100 ohne die Leiterplatte 200. In dieser Explosionsansicht ist ein rechnerseitiges Verbinderelement 10 und ein kartenseitiges Verbinderelement 30 des Verbindersystems 100 separat, d.h. in einem nicht zusammengesteckten Zustand gezeigt. Im vollständig montierten Zustand sind das rechnerseitige Verbinderelement 10 und das kartenseitige Verbinderelement 30 miteinander verbunden, d.h. entlang einer mit einem Pfeil gekennzeichneten ersten Montagerichtung M1 zusammengesteckt.

Das rechnerseitige Verbinderelement 10 ist ausgelegt, um mit einer rechnerseitigen Steckseite 14 voran an einen Zentralrechner eines Kraftfahrzeugs (nicht gezeigt) angeschlossen bzw. angesteckt zu werden, z.B. in die in Figur 1 gezeigte Leiterplatte 200. Im gezeigten Ausführungsbeispiel ist die Steckseite 14 im montierten Zustand diejenige Seite des rechnerseitigen Verbinderelements 10, welche dem kartenseitigen Verbinderelement 30 abgewandt ist. Eine Normale auf die rechnerseitige Steckseite 14 ist etwa entgegengesetzt parallel zur ersten Montagerichtung M1 angeordnet.

Das rechnerseitige Verbinderelement 10 weist eine Mehrzahl von Kontaktelementen 13a, 13b und 13c auf, die über die Leiterplatte 200 mit komplementären Kontaktelementen des Zentralrechners verbunden werden können. Im Ausführungsbeispiel der Figur 2 weist das Verbindersystem 100 bzw. das rechnerseitige Verbinderelement 10 (und analog dazu das kartenseitige Verbinderelement 30) drei unterschiedliche Kontaktbereiche auf, nämlich einen Single-End-Kontaktbereich mit einer Mehrzahl Single-End-Kontaktelementen 13a, einen Differential-Pair-Kontaktbereich mit einer Mehrzahl Differential-Pair-Kontaktelementen 13b und einen Power-Kontaktbereich mit einer Mehrzahl Power-Kontaktelementen 13c. Während die Single-End-Kontaktelemente 13a Signale bzw. Informationen jeweils nur über einen elektrischen Leiter übertragen, so werden bei den Differential-Pair-Kontaktelementen 13b jeweils zwei elektrische Leiter verwendet, um ein Differenzsignal dieser beiden Leiter zu übertragen. Die Power-Kontaktelemente 13c sind im gezeigten Ausführungsbeispiel ähnlich wie die Differential-Pair-Kontaktelemente jeweils paarweise ausgeführt und dienen zur Leistungsübertragung.

Das rechnerseitige Verbinderelement 10 weist ein rechnerseitiges Gehäuse 20 mit einer Mehrzahl von rechnerseitigen Kontakthohlräumen 11a, 11b, und 11c auf, nämlich einem rechnerseitigen Single-Pair-Kontakthohlraum 11a, einer Mehrzahl (hier genau 48) rechnerseitige Differential-Pair-Kontakthohlräume 11b und einen rechnerseitigen Power-Kontakthohlraum 11c. Sämtliche Kontakthohlräume 11a-11c sind durch das rechnerseitige Gehäuse 20 hindurch verlaufend ausgebildet und durchdringen somit das rechnerseitige Gehäuse 20 vollständig. Die Kontakthohlräume 11a-11c weisen (in erster Montagerichtung M1, siehe unten) einen etwa konstanten Querschnitt auf, welcher z.B. etwa rechteckig ausgebildet ist. Ferner weist das rechnerseitige Verbinderelement 10 eine Mehrzahl von rechnerseitigen Isolierkörpern 12a, 12b und 12c auf, welche jeweils zumindest einen Isolierraum ausbilden und umschließen, der durch das rechnerseitige Gehäuse 20 hindurch verlaufend ausgebildet ist.

Die Isolierkörper 12a, 12b und 12c sind innerhalb der rechnerseitigen Kontakthohlräume 11a-11c angeordnet. Im gezeigten Ausführungsbeispiel weist das rechnerseitige Verbinderelement 10 einen rechnerseitigen Single-Pair-Isolierkörper 12a auf, eine Mehrzahl (hier genau 48) rechnerseitige Differential-Pair-Isolierkörper 12b und einen rechnerseitigen Power-Isolierkörper 12c.

Die rechnerseitigen Kontaktelemente 13a-13c sind im montierten Zustand zumindest bereichsweise innerhalb von rechnerseitigen Isolierhohlräumen der jeweils zugehörigen rechnerseitigen Isolierkörper 12a-12c angeordnet. So sind die Single-End-Kontaktelemente 13a im Single-End-Kontakthohlraum 11a und innerhalb von Isolierhohlräumen des Single-End-Isolierkörpers 12a angeordnet. Die Differential-Pair-Kontaktelemente 13b sind jeweils in zugehörigen Differential-Pair-Kontakthohlräumen 11b und innerhalb von zugehörigen Isolierhohlräumen der Differential-Pair-Isolierkörper 12b angeordnet. Die Power-Kontaktelemente 13c sind in dem Power-Kontakthohlraum 11c und jeweils innerhalb von zugehörigen Isolierhohlräumen des Power-Isolierkörpers 12c angeordnet.

Das rechnerseitige Gehäuse 20 kann zumindest eine Schrauböffnung 22 aufweisen, im gezeigten Ausführungsbeispiel genau zwei Schrauböffnungen 22. Jede Schrauböffnung 22 ist einstückig mit dem Gehäuse 20 als Zinkdruckgussbauteil ausgebildet. Die Schrauböffnungen 22 sind an einem Rand der rechnerseitigen Steckseite 14 des rechnerseitigen Gehäuses 20 ausgebildet. Dabei weist jede Schrauböffnung 22 eine kreisförmige Umrandung auf, welche einen Hohlzylinderabschnitt umgibt, in welchen eine Schraube eingeschraubt werden kann. Die Zylinderachse des Hohlzylinderabschnitts ist etwa parallel zur ersten Montagerichtung M1 und/oder zu den kartenseitigen Kontaktelementen 13a-13c angeordnet. Somit kann das rechnerseitige Gehäuse 20 mittels in die Schrauböffnungen 22 geschraubte Schrauben an dem (nicht gezeigten) Zentralrechner befestigt werden. Dabei werden die Schrauben in etwa parallel zu den rechnerseitigen Kontaktelementen 13a-13c durch die Schrauböffnungen geschraubt. Dadurch wird die Befestigung des rechnerseitigen Verbinderelements 10 am Zentralrechner verstärkt und/oder gesichert.

Das kartenseitige Verbinderelement 30 ist ausgelegt, um mit einer PCB-Karte entlang einer zweiten Montagerichtung M2 verbunden zu werden. Als PCB-Karte kann z.B. die in Figur 1 gezeigte Leiterplatte 200 vorgesehen sein. Dazu weist das kartenseitige Verbinderelement 30 auf seiner Unterseite, der kartenseitigen Steckseite 34, rechnerseitigen Kontaktelementen 13a-13c entsprechende kartenseitige Kontaktelemente 33a-33c auf (nicht in den Figuren gezeigt). Dabei sind die kartenseitigen Kontaktelemente etwa rechtwinklig ausgebildet mit einem ersten Abschnitt, der sich etwa parallel zur ersten Montagerichtung M1 erstreckt, und einem zweiten Abschnitt, der sich etwa parallel zur zweiten Montagerichtung M2 erstreckt. Der zweite Abschnitt der kartenseitigen Kontaktelemente kann hierbei aus der kartenseitigen Steckseite 34 herausragen zum (elektrischen und/oder physikalischen) kontaktieren der PCB-Karte, also z.B. der Leiterplatte 200.

Wie in der Figur 2 gezeigt, ist die zweite Montagerichtung M2 im Wesentlichen senkrecht zur ersten Montagerichtung M1 ausgerichtet. Das kartenseitige Verbinderelement 30 ist dazu ausgebildet und vorgesehen, mit seiner kartenseitigen Steckseite 34 voran in Richtung der zweiten Montagerichtung M2 an der (nicht gezeigten) PCB-Karte befestigt, z.B. verlötet, zu werden. Die kartenseitige Steckseite 34 ist im montierten Zustand in einer Ebene angeordnet, die etwa senkrecht zu der Ebene angeordnet ist, in der die rechnerseitige Steckseite 14 angeordnet ist.

Das kartenseitige Verbinderelement 30 weist ein kartenseitiges Gehäuse 40 mit einer Mehrzahl von kartenseitigen Kontakthohlräumen 31a-31c auf. Dabei kann das kartenseitige Gehäuse 40 einstückig ausgebildet sein oder zumindest zwei kartenseitige Gehäuseelemente aufweisen, welche miteinander verbunden bzw.
zusammengesteckt werden können.

Das kartenseitige Gehäuse 40 weist eine Mehrzahl von kartenseitigen Isolierkörpern 32a-32c auf, welche im montierten Zustand innerhalb der kartenseitigen Kontakthohlräume 31a-31c angeordnet sind. Die kartenseitigen Isolierkörper 32a-32c wiederum weisen kartenseitige Isolierhohlräume auf, die ausgelegt sind, um im montierten Zustand zugehörige rechnerseitige Kontaktelemente 13a-13c zumindest bereichsweise aufzunehmen. Sowohl die kartenseitigen Kontakthohlräume 31a-31c, die kartenseitigen Isolierkörpern 32a-32c, als auch die kartenseitigen Kontaktelemente sind winklig ausgebildet. Die kartenseitigen Kontakthohlräume 31a-31c usw. weisen dabei einen ersten Abschnitt auf, welcher etwa parallel zur ersten Montagerichtung M1 ausgebildet ist, und einen zweiten Abschnitt, welcher etwa parallel zur zweiten Montagerichtung M2 ausgebildet ist.

Im gezeigten Ausführungsbeispiel weist das kartenseitige Verbinderelement 30 einen kartenseitigen Single-Pair-Isolierkörper 32a, eine Mehrzahl (hier genau 48) kartenseitige Differential-Pair-Isolierkörper 32b und einen kartenseitigen Power-Isolierkörper 32c auf. Die kartenseitigen Kontaktelemente (nicht in Figur 2 gezeigt) sind im montierten Zustand zumindest bereichsweise innerhalb von kartenseitigen Isolierhohlräumen der jeweils zugehörigen kartenseitigen Isolierkörper 32a-32c angeordnet. So sind Single-End-Kontaktelemente im Single-End-Kontakthohlraum 31a und innerhalb von Isolierhohlräumen des Single-End-Isolierkörpers 32a angeordnet. Differential-Pair-Kontaktelemente sind jeweils in zugehörigen Differential-Pair-Kontakthohlräumen 31b und innerhalb von zugehörigen Isolierhohlräumen der Differential-Pair-Isolierkörper 32b angeordnet. Power-Kontaktelemente sind in dem Power-Kontakthohlraum 31c und innerhalb von zugehörigen Isolierhohlräumen des Power-Isolierkörpers 32c angeordnet.

Im montierten Zustand, in dem das rechnerseitige Verbinderelement 10 mit dem kartenseitigen Verbinderelement 30 verbunden und/oder zusammengesteckt ist, kontaktieren sich die rechnerseitigen Kontaktelemente 13a-13c und die kartenseitigen Kontaktelemente in den kartenseitigen Kontakthohlräumen 31a-31c und in den Isolierhohlräumen der kartenseitigen Isolierkörper 32a-32c.

Das rechnerseitige Gehäuse 20 kann eine Mehrzahl von Stabilisierungselementen aufweisen, während das kartenseitige Gehäuse 40 eine entsprechende Anzahl von komplementären Stabilisierungselementen aufweisen kann. Beim Zusammenstecken des rechnerseitigen Verbinderelements 10 und des kartenseitigen Verbinderelements 30 greifen die Stabilisierungselemente ineinander ein und stabilisieren die Steckverbindung im montierten Zustand. Zusätzlich können die Stabilisierungselemente auch als Steckhilfe dienen.

Das kartenseitige Gehäuse 40 kann zudem zumindest ein Führungselement 52 aufweisen, z.B. einen Vorsprung, welcher beim Zusammenstecken des rechnerseitigen Verbinderelements 10 und des kartenseitigen Verbinderelements 30 in ein komplementäres Führungselement 54 des rechnerseitigen Gehäuses 10 eingreift. Dabei kann eines der Führungselemente 52 länglich ausgebildet sein, etwa parallel zur ersten Montagerichtung M1 ausgerichtet sein und/oder sich in Richtung zum zugeordneten Verbinderelement 10 bzw. 30 hin verjüngend ausgebildet sein. Dies erleichtert das Ausrichten des rechnerseitigen und kartenseitigen Verbinderelements 10 und 30 beim Zusammenstecken und somit die Montage des Verbindersystems 100.

Das rechnerseitige Gehäuse 20 und das kartenseitige Gehäuse 40 können jeweils aus Zinkdruckguss ausgebildet und gefertigt sein, in welchem die Kontakthohlräume 12a-12c bzw. 32a-32c vorgesehen sind. Dadurch kann bewirkt werden, dass die rechnerseitigen Kontaktelemente 13a-13c und die kartenseitigen Kontaktelemente nicht nur mechanisch geschützt sind, sondern auch elektrisch geschirmt sind, um elektromagnetische Störeinflüsse zu reduzieren und/oder zu vermeiden. Die Signalqualität kann dadurch signifikant erhöht werden.

Ferner kann das kartenseitige Gehäuse 40 ein Federelement aufweisen, welches das kartenseitige Gehäuse 40 elektrisch kontaktiert und welches ausgelegt ist, um im montierten Zustand auch das rechnerseitige Gehäuse 20 elektrisch zu kontaktieren. Somit besteht ein elektrischer Kurzschluss zwischen den beiden Gehäusen 20 und 40, was die Schirmung der Kontaktelemente und damit die Signalqualität weiter verbessert.

Das rechnerseitige Verbinderelement 10 und das kartenseitige Verbinderelement 30 können z.B. eine Länge (etwa senkrecht zu den beiden Montagerichtungen M1 und M2) von etwa 85 mm, eine Tiefe (etwa parallel zur ersten Montagerichtung M1) von etwa 15 mm und eine Höhe (etwa parallel zur zweiten Montagerichtung M2) von etwa 12 mm aufweisen. Diese Abmessungen sind lediglich beispielhaft für den Automotive-Bereich und können je nach Anwendung auch andere für den Automotive Bereich geeignete Dimensionen einnehmen.

Im Verbindersystem 100 sind die rechnerseitigen und kartenseitigen Differential-Pair-Kontaktelemente 13b und 33b in voneinander beabstandeten Reihen angeordnet, die den in Figur 1 gezeigten Reihen von Paarkontaktstellen 210 entsprechen. Dabei sind die Reihen von Differential-Pair-Kontaktelementen 13b und 33b so in Spaltenrichtung voneinander beabstandet, dass zwischen ihnen ausreichend Platz für die Routing-Kanäle (z.B. 230 und 232) verbleibt.

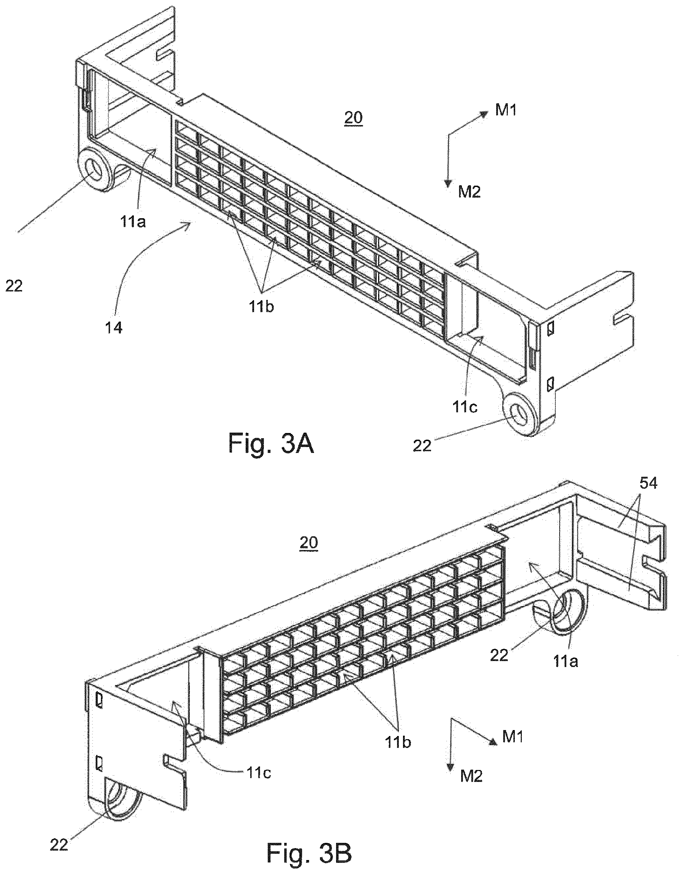

Die **Figur 3A** zeigt in einer ersten perspektivischen Ansicht (schräge Vorderansicht) eine schematische Skizze des rechnerseitigen Gehäuses 20 des in Figur 2 gezeigten Verbindersystems 100, während die **Figur 3B** das rechnerseitige Gehäuse 20 in einer zweiten perspektivischen Ansicht (schräge Rückansicht) zeigt. In den Figuren 3A und 3B sind nochmals die Kontakthohlräume 11a-11c gezeigt, welche das rechnerseitige Gehäuse 20 vollständig durchdringen und einen etwa rechteckigen Querschnitt aufweisen.

Wie in den Figuren 3A und 3B gezeigt, weist insbesondere jeder einzelne der Kontakthohlräume 11b einen etwa rechteckigen Querschnitt auf zum drehfesten Aufnehmen der Differential-Pair-Isolierkörper 12b. Beim Zusammenstecken des rechnerseitigen Verbinderelements 10 und des kartenseitigen Verbinderelements 30, d.h. im montierten Zustand, werden von den rechnerseitigen Kontakthohlräume 11a-11c und den kartenseitigen Kontakthohlräume 31a-31c zusammen durchgängige Kanäle und/oder Hohlräume für die Kontaktelemente ausgebildet.

Im montierten Zustand können die beiden Gehäuse 20 und 40 aneinander gekoppelt und/oder elektrisch kontaktiert sein, was die Schirmung verbessert.

Eine erste Schrauböffnung 22 ist benachbart zum rechnerseitigen Single-End Kontakthohlraum 11a am rechnerseitigen Gehäuse 20 ausgebildet. Eine zweite Schrauböffnung 22 ist benachbart zum rechnerseitigen Power Kontakthohlraum 11c am rechnerseitigen Gehäuse 20 ausgebildet.

Jede Schrauböffnung 22 ist als (z.B. flächige) Vergrößerung der rechnerseitigen Steckseite 14 ausgebildet und kann schlaufenartig vom rechnerseitigen Gehäuse 20 abstehen. Im gezeigten Ausführungsbeispiel stehen die etwa kreisförmigen Umrandungen der Schrauböffnungen 22 in etwa in der zweiten Montagerichtung M2 vom rechnerseitigen Gehäuse 20 ab.

Auch das in Figur 2 gezeigte kartenseitige Gehäuse 40 kann Schrauböffnungen aufweisen (nicht in den Figuren gezeigt), welche als Zinkdruckguss-Elemente ausgebildet sein können und zum Verstärken der Verbindung des kartenseitigen Verbinderelements 30 mit der PCB-Karte dienen. Schrauböffnungen am kartenseitigen Gehäuse 40 können z.B. als Vergrößerung der kartenseitigen Steckseite 34 ausgebildet sein (vgl. Fig. 2).

Deswegen kann auch die in Figur 1 gezeigte Leiterplatte 200 Aufnahmen mit z.B. einem Gewinde aufweisen, in denen Schrauben durch die Schrauböffnungen des Verbindersystems 100 an der Leiterplatte 200 verschraubbar sind.

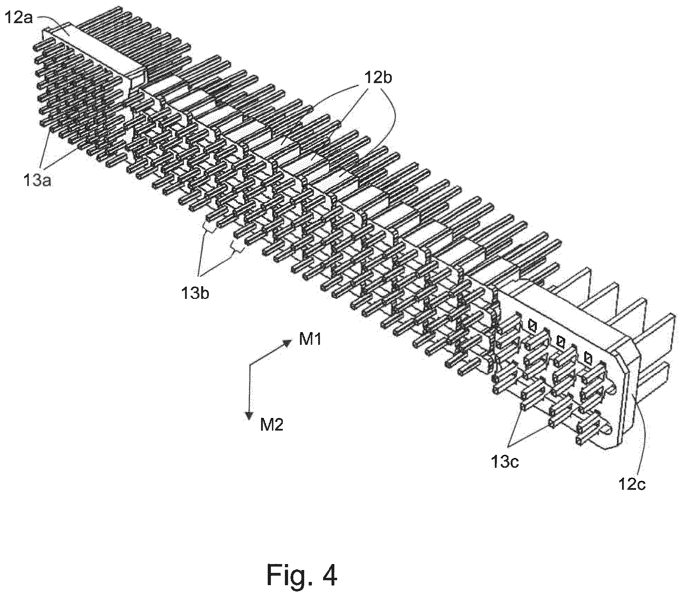

Die **Figur 4** zeigt eine schematische Skizze des rechnerseitigen Verbinderelements 10 aus Figur 2. Im Vergleich zur Figur 2 wurde in der Figur 4 z.B. das rechnerseitige Gehäuse 20 ausgeblendet, so dass die rechnerseitigen Isolierkörper 12a-12c und die rechnerseitigen Kontaktelemente 13a-13c besser gezeigt sind. Insbesondere ist in Figur 4 gezeigt, dass die hohlförmigen Isolierkörper 12a-12c die Kontaktelemente 13a-13c zumindest bereichsweise umgeben. Mit anderen Worten sind die Kontaktelemente 13a-13c zumindest bereichsweise innerhalb von Hohlräumen der Isolierkörper 12a-12c angeordnet.

Die in Figur 1 abschnittsweise gezeigte Leiterplatte 200 kann neben den Paarkontaktstellen 210 und zugehörigen Routing-Kanälen weiterhin auch Single-End-Kontaktstellen und/oder Power-Kontaktstellen zum Kontaktieren der rechnerseitigen und/oder kartenseitigen Single-End-Kontaktelemente 13a, 33a und/oder Power Kontaktelemente 13c, 33c aufweisen. Diese können auf der Leiterplatte durch Single-End-Routing-Kanäle und/oder Power-Routing-Kanäle geroutet sein, deren Lage, Länge und weitere Ausbildung im Wesentlichen denen der in Fig. 1 gezeigten Routing-Kanäle 230, 232 entsprechen.

Somit kann die Leiterplatte 200 einen Differential-Pair-Kontaktbereich aufweisen, in welchem die Paarkontaktstelle 210 in Reihen zusammen mit den zugehörigen Routing-Kanälen (z.B. 230, und 232) angeordnet sind, in Spaltenrichtung S benachbart dazu angeordnet einen Single-End-Kontaktbereich, in welchem die Single-End-Kontaktstellen in Reihen zusammen mit den zugehörigen Single-End-Routing-Kanälen angeordnet sind, und auf der anderen Seite des Differential-Pair-Bereichs in Spaltenrichtung S benachbart einen Power-Kontaktbereich, in welchem die Power-Kontaktstellen in Reihen zusammen mit den zugehörigen Power-Routing-Kanälen angeordnet sind.

Somit kann die Leiterplatte 200 zum Kontaktieren und/oder Routen sämtlicher Kontaktelemente 13a-c, 33a-c des kartenseitigen und/oder rechnerseitigen Verbinderelements 10, 30 ausgebildet sein.

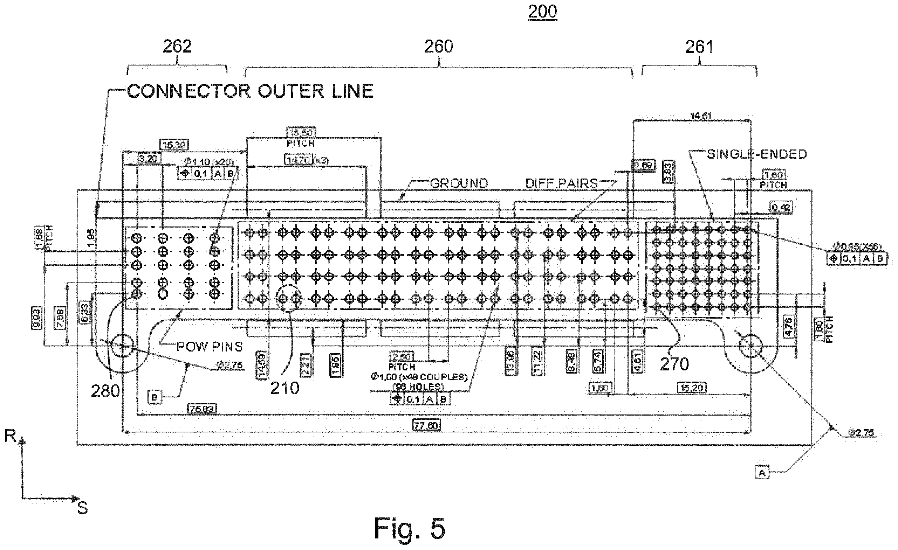

Die **Figur 5** zeigt das Layout einer Leiterplatte 200 zum Kontaktieren des rechnerseitigen Verbinderelements 10 des Verbindungssystems 100.

Hierbei sind in ein einem mittleren Differential-Pair-Kontaktbereich 260 die Paarkontaktstellen 210 in zwölf Reihen von jeweils vier einzelnen Paarkontaktstellen 210 angeordnet. Hierbei ist exemplarisch lediglich eine einzige Paarkontaktstelle 210 mit einem Bezugszeichen gekennzeichnet. Zwischen den einzelnen Reihen von Paarkontaktstellen 210 sind die Routing-Kanäle mit den Leiterbahnen 240 (vgl. Fig. 1) angeordnet, die in Figur 5 nicht gezeigt sind.

In Spaltenrichtung S benachbart zu dem mittleren Differential-Pair-Kontaktbereich 260 sind in einem (rechts gezeigten) Single-End-Kontaktbereich 261 Single-End-Kontaktstellen 270 in acht Reihen von jeweils sieben einzelnen Single-End-Kontaktstellen 270 angeordnet. Hierbei ist exemplarisch lediglich eine einzige Single-End-Kontaktstelle 270 mit einem Bezugszeichen gekennzeichnet.

Zwischen den einzelnen Reihen von Single-End-Kontaktstellen 270 können Single-End-Routing-Kanäle angeordnet sein, die in Figur 5 nicht gezeigt sind.

Gegen die Spaltenrichtung S benachbart zu dem mittleren Differential-Pair-Kontaktbereich 260 sind in einem (links gezeigten) Power-Kontaktbereich 262 Power-Kontaktstellen 280 in vier Reihen von jeweils fünf einzelnen Power-Kontaktstellen 280 angeordnet. Hierbei ist exemplarisch lediglich eine einzige Power-Kontaktstelle 280 mit einem Bezugszeichen gekennzeichnet.

Zwischen den einzelnen Reihen von Power-Kontaktstellen 280 können Power-Routing-Kanäle angeordnet sein, die in Figur 5 nicht gezeigt sind.

Die Reihen von Paarkontaktstellen 210, Single-End-Kontaktstellen 270 und Power-Kontaktstellen 280 können alle in Reihenrichtung R ausgerichtet sein.

Figur 5 zeigt weiterhin eine Bemaßung des gezeigten Ausführungsbeispiels, einschließlich eines Abstands zwischen den einzelnen Reihen von Kontaktstellen. In diesem Reihenabstand können die Routing-Kanäle angeordnet sein.

Dabei kann die Leiterplatte 200 etwa 1,20 mm +/- 0,10 mm dick ausgebildet sein.

Die Einzelkontaktstellen der Paarkontaktstellen 210, die Single-End-Kontaktstellen 270 und/oder die Power-Kontaktstellen 280 können Bohrungen mit einem Durchmesser von etwa 0,30 mm bis etwa 0,50 mm aufweisen, bevorzugt etwa 0,40 mm.

### Bezugszeichenliste

- 10: rechnerseitiges Verbinderelement
- 11a: rechnerseitiger Single-End Kontakthohlraum
- 11b: rechnerseitiger Differential-Pair Kontakthohlraum
- 11c: rechnerseitiger Power Kontakthohlraum
- 12a: rechnerseitiger Single-End Isolierkörper
- 12b: rechnerseitiger Differential-Pair Isolierkörper
- 12c: rechnerseitiger Power Isolierkörper
- 13a: rechnerseitiges Single-End Kontaktelement
- 13b: rechnerseitiges Differential-Pair Kontaktelement
- 13c: rechnerseitiges Power Kontaktelement
- 14: rechnerseitige Steckseite
- 20: rechnerseitiges Gehäuse / Zinkdruckguss-Gehäuse
- 22: Schrauböffnung
- 30: kartenseitiges Verbinderelement
- 31a: kartenseitiger Single-End Kontakthohlraum
- 31b: kartenseitiger Differential-Pair Kontakthohlraum
- 31c: kartenseitiger Power Kontakthohlraum
- 32a: kartenseitiger Single-End Isolierkörper
- 32b: kartenseitiger Differential-Pair Isolierkörper
- 32c: kartenseitiger Power Isolierkörper
- 33a: kartenseitiges Single-End Kontaktelement
- 33b: kartenseitiges Differential-Pair Kontaktelement
- 33c: kartenseitiges Power Kontaktelement
- 34: kartenseitige Steckseite
- 40: kartenseitiges Gehäuse / Zinkdruckguss-Gehäuse
- 52: Führungselement
- 54: komplementäres Führungselement
- 100: Verbindersystem

- 200: Leiterplatte
- 210: Paarkontaktstelle
- 220: Einzelkontaktstelle
- 230: erster Routing-Kanal
- 232: zweiter Routing-Kanal
- 240: Leiterbahnen
- 250: Anschlussende
- 260: Differential-Pair-Kontaktbereich
- 261: Single-End-Kontaktbereich
- 262: Power-Kontaktbereich
- 270: Single-End-Kontaktstelle
- 280: Power-Kontaktstelle

- G1: erste Gruppe
- G2: zweite Gruppe
- M1: erste Montagerichtung
- M2: zweite Montagerichtung
- R1: erste Reihe
- R2: zweite Reihe
- R: Reihenrichtung
- S: Spaltenrichtung

## Patentansprüche

1. Leiterplatte (200) zum kartenseitigen und/oder rechnerseitigen Kontaktieren eines Verbindersystems (100), wobei das Verbindersystem (100) zum Verbinden einer PCB-Karte mit einem Zentralrechner eines Kraftfahrzeugs ausgebildet ist, und wobei durch das Verbindersystem (100) Differential-Pair-Signale entlang von Differential-Pair-Kontaktelementen (13b, 33b) des Verbindersystems (100) leitbar sind, mit:
- einer Mehrzahl von Paarkontaktstellen (210) zum Kontaktieren von Differential-Pair-Kontaktelementen (13b; 33b) des Verbindersystems (100), wobei jede Paarkontaktstelle (210) zwei Einzelkontaktstellen (220) zum Kontaktieren von einzelnen Kontaktelementen des jeweiligen Differential-Pair-Kontaktelements (13b; 33b) des Verbindersystems (100) aufweist,
- zumindest einem ersten Routing-Kanal (230), durch welchen Leiterbahnen (240) zu den Einzelkontaktstellen (220) zumindest einer der Paarkontaktstellen (210) geführt sind;
wobei
- eine erste Gruppe (G1) der Paarkontaktstellen (210) hintereinander in einer ersten Reihe (R1) auf der Leiterplatte (200) angeordnet ist,
- eine zweite Gruppe (G2) der Paarkontaktstellen (210) hintereinander in einer zweiten Reihe (R2) auf der Leiterplatte (200) angeordnet ist, wobei die zweite Reihe (R2) parallel zu der ersten Reihe (R1) angeordnet ist
- durch den ersten Routing-Kanal (230) Leiterbahnen (240) zu den beiden Einzelkontaktstellen (220) zumindest einer der Paarkontaktstellen (210) der ersten Gruppe (G1) geführt sind,
- der erste Routing-Kanal (230) zwischen der ersten Reihe (R1) und der zweiten Reihe (R2) so angeordnet ist, dass er parallel zu der ersten und zweiten Reihe (R1, R2) angeordnet ist,
- durch den ersten Routing-Kanal (230) Leiterbahnen (240) zu den beiden Einzelkontaktstellen (220) sämtlicher Paarkontaktstellen (210) der ersten Gruppe (G1) geführt sind, die nicht an einem Anschlussende (250) der ersten Reihe (R1) angeordnet sind, zu welchem die Leiterbahnen (240) von den Einzelkontaktstellen (220) weg durch den Routing-Kanal (230) geführt sind, **dadurch gekennzeichnet, dass**
- die Leiterbahnen (240) zu den Einzelkontaktstellen (220) der Mehrzahl von Paarkontaktstellen (210) der ersten Gruppe (G1) in zumindest drei Ebenen übereinander durch den ersten Routing-Kanal (230) geführt sind, wobei die Leiterbahnen (240) zu den Einzelkontaktstellen (220) derjenigen Paarkontaktstelle (210) der ersten Gruppe (G1), die am weitesten vom Anschlussende (250) entfernt angeordnet ist, in derselben Ebene durch den ersten Routing-Kanal (230) geführt sind, und die Leiterbahnen (240) zu zwei mittleren Paarkontaktstellen (210) der ersten Gruppe (G1) in jeweils einer anderen Ebene durch den ersten Routing-Kanal (230) geführt sind.

2. Leiterplatte (200) nach Anspruch 1, wobei die Leiterbahnen (240) durch den ersten Routing-Kanal (230) zumindest bis zu einem Anschlussende (250) der ersten Reihe (R1) geführt sind.

3. Leiterplatte (200) nach einem der vorangegangenen Ansprüche, wobei zwischen den Ebenen, in denen die Leiterbahnen (240) zu den beiden Einzelkontaktstellen (220) der unterschiedlichen Paarkontaktstellen (210) der ersten Gruppe (G1) übereinander durch den ersten Routing-Kanal (230) geführt sind, jeweils eine elektrische Schirmung ausgebildet ist.

4. Leiterplatte (200) nach einem der vorangegangenen Ansprüche, mit einem zweiten Routing-Kanal (232), durch welchen Leiterbahnen (240) zu den Einzelkontaktstellen (220) zumindest einer der Paarkontaktstellen (210) der zweiten Gruppe (G2) geführt sind, wobei der zweite Routing-Kanal (220) benachbart zur zweiten Reihe (R2) so angeordnet ist, dass er parallel zu der ersten und zweiten Reihe (R1, R2) angeordnet ist.

5. Leiterplatte (200) nach einem der vorangegangenen Ansprüche, mit einer vorbestimmten Reihenanzahl an Reihen (R1, R2) von Paarkontaktstellen (210), welche etwa parallel zueinander angeordnet sind, wobei
- jeder Reihe (R1; R2) von Paarkontaktstellen (210) genau ein Routing-Kanal (230; 232) zugeordnet ist, durch den Leiterbahnen (240) zu sämtlichen Paarkontaktstellen (210) der zugeordneten Reihe (R1; R2) geführt sind, die nicht an einem Anschlussende (250) dieser Reihe (R1; R2) angeordnet sind,
- diese Routing-Kanäle (230, 232) parallel zu den Reihen (R1, R2) von Paarkontaktstellen (210) angeordnet sind und
- die Reihen (R1, R2) von Paarkontaktstellen (210) und diese Routing-Kanäle (230, 232) jeweils alternierend nebeneinander zueinander angeordnet sind, wobei neben jeder Reihe (R1; R2) von Paarkontaktstellen (210) der jeweils zugeordnete Routing-Kanal (230; 232) ausgebildet ist.

6. Leiterplatte (200) nach einem der vorangegangenen Ansprüche mit zumindest zehn Reihen (R1, R2) von Paarkontaktstellen (210), denen jeweils zumindest ein Routing-Kanal (230; 232) zugeordnet ist.

7. Leiterplatte (200) nach einem der vorangegangenen Ansprüche, wobei jede Reihe (R1, R2) zumindest vier Paarkontaktstellen (210) aufweist.

8. Leiterplatte (200) nach einem der vorangegangenen Ansprüche, mit neben den Reihen (R1, R2), in denen die Paarkontaktstellen (210) ausgebildet sind, angeordneten Power-Kontaktstellen zum kartenseitigen und/oder rechnerseitigen Kontaktieren von Power-Kontaktelementen (13c; 33c) des Verbindersystems (100).

9. Leiterplatte (200) nach einem der vorangegangenen Ansprüche, mit neben den Reihen (R1, R2), in denen die Paarkontaktstellen (210) ausgebildet sind, angeordneten Single-End-Kontaktstellen zum kartenseitigen und/oder rechnerseitigen Kontaktieren von Single-End-Kontaktelementen (13a; 33a) des Verbindersystems (100).

10. Leiterplatte (200) nach einem der Ansprüche 8 oder 9, wobei die Power-Kontaktstellen und/oder die Single-End-Kontaktstellen in Reihen angeordnet sind, die parallel zu den Reihen (R1, R2) angeordnet sind, in denen die Paarkontaktstellen (210) ausgebildet sind.

11. Verbindersystem (100) zum Verbinden einer PCB-Karte mit einem Zentralrechner eines Kraftfahrzeugs, aufweisend ein rechnerseitiges Verbinderelement (10) mit einer Mehrzahl von rechnerseitigen Differential-Pair-Kontaktelementen (13b) und ein kartenseitiges Verbinderelement (30) mit einer Mehrzahl von kartenseitigen Differential-Pair-Kontaktelementen (33b), mit zumindest einer Leiterplatte (200) nach einem der vorangegangenen Ansprüche zum kartenseitigen und/oder rechnerseitigen Kontaktieren der kartenseitigen und/oder rechnerseitigen Differential-Pair-Kontaktelemente (13b; 33b).

12. Verbindersystem (100) nach Anspruch 11, wobei
das rechnerseitige Verbinderelement (10) aufweist:
- ein rechnerseitiges Zinkdruckguss-Gehäuse (20) mit zumindest einem rechnerseitigen Kontakthohlraum (11a-11c);
- zumindest einen rechnerseitigen Isolierkörper (12a-12c), welcher im montierten Zustand innerhalb des zumindest einen rechnerseitigen Kontakthohlrraums (11a-11c) angeordnet ist;
- eine Mehrzahl von rechnerseitigen Kontaktelementen (13a-13c), welche im montierten Zustand zumindest bereichsweise innerhalb von rechnerseitigen Isolierhohlräumen in dem zumindest einen rechnerseitigen Isolierkörper (12a-12c) angeordnet sind; und wobei
das kartenseitige Verbinderelement (30) aufweist:
- ein kartenseitiges Zinkdruckguss-Gehäuse (40) mit zumindest einem kartenseitigen Kontakthohlraum (31a-31c);
- zumindest einen kartenseitigen Isolierkörper (32a-32c), welcher im montierten Zustand innerhalb des zumindest einen kartenseitigen Kontakthohlraums (31a-31c) angeordnet ist und eine Mehrzahl kartenseitige Isolierhohlräume aufweist, die ausgelegt sind, um im montierten Zustand die rechnerseitigen Kontaktelemente (13a-13c) zumindest bereichsweise aufzunehmen; und
- eine Mehrzahl von kartenseitigen Kontaktelementen (33a-33c), welche im montierten Zustand zumindest bereichsweise innerhalb der kartenseitigen Isolierhohlräume angeordnet sind und die rechnerseitigen Kontaktelemente (13a-13c) elektrisch kontaktieren.

13. Verfahren zum Herstellen einer Leiterplatte (200) zum kartenseitigen und/oder rechnerseitigen Kontaktieren eines Verbindersystems (100), wobei das Verbindersystem (100) zum Verbinden einer PCB-Karte mit einem Zentralrechner eines Kraftfahrzeugs ausgebildet ist, und wobei durch das Verbindersystem (100) Differential-Pair-Signale entlang von Differential-Pair-Kontaktelementen (13b, 33b) des Verbindersystems (100) leitbar sind, mit den Schritten:
- Ausbilden einer Mehrzahl von Paarkontaktstellen (210) zum Kontaktieren von Differential-Pair-Kontaktelementen (13b; 33b) des Verbindersystems (100), wobei jede Paarkontaktstelle (210) zwei Einzelkontaktstellen (220) zum Kontaktieren von einzelnen Kontaktelementen des jeweiligen Differential-Pair-Kontaktelements (13b; 33b) des Verbindersystems (100) aufweist,
- Ausbilden zumindest eines ersten Routing-Kanals (230), durch welchen Leiterbahnen (240) zu den Einzelkontaktstellen (220) zumindest einer der Paarkontaktstellen (210) geführt sind;
wobei
- eine erste Gruppe (G1) der Paarkontaktstellen (210) hintereinander in einer ersten Reihe (R1) auf der Leiterplatte (200) angeordnet wird,
- eine zweite Gruppe (G2) der Paarkontaktstellen (210) hintereinander in einer zweiten Reihe (R2) auf der Leiterplatte (200) angeordnet wird, wobei die zweite Reihe (R2) parallel zu der ersten Reihe (R1) angeordnet wird.
- durch den ersten Routing-Kanal (230) Leiterbahnen (240) zu den beiden Einzelkontaktstellen (220) zumindest einer der Paarkontaktstellen (210) der ersten Gruppe (G1) geführt werden,
- der erste Routing-Kanal (230) zwischen der ersten Reihe (R1) und der zweiten Reihe (R2) so angeordnet wird, dass er parallel zu der ersten und zweiten Reihe (R1, R2) angeordnet wird, und
- durch den ersten Routing-Kanal (230) Leiterbahnen (240) zu den beiden Einzelkontaktstellen (220) sämtlicher Paarkontaktstellen (210) der ersten Gruppe (G1) geführt sind, die nicht an einem Anschlussende (250) der ersten Reihe (R1) angeordnet sind, zu welchem die Leiterbahnen (240) von den Einzelkontaktstellen (220) weg durch den Routing-Kanal (230) geführt sind, **dadurch gekennzeichnet, dass**
- die Leiterbahnen (240) zu den Einzelkontaktstellen (220) der Mehrzahl von Paarkontaktstellen (210) der ersten Gruppe (G1) in zumindest drei Ebenen übereinander durch den ersten Routing-Kanal (230) geführt sind, wobei die Leiterbahnen (240) zu den Einzelkontaktstellen (220) derjenigen Paarkontaktstelle (210) der ersten Gruppe (G1), die am weitesten vom Anschlussende (250) entfernt angeordnet ist, in derselben Ebene durch den ersten Routing-Kanal (230) geführt sind, und die Leiterbahnen (240) zu zwei mittleren Paarkontaktstelle (210) der ersten Gruppe (G1) in jeweils einer anderen Ebene durch den ersten Routing-Kanal (230) geführt sind.

## Claims

1. Printed circuit board (200) for contacting a connector system (100) on the card side and/or computer side, wherein the connector system (100) is designed to connect a PCB card to a central computer of a motor vehicle, and wherein differential pair signals can be conducted through the connector system (100) along differential pair contact elements (13b, 33b) of the connector system (100), having:
- a plurality of pair contact points (210) for contacting differential pair contact elements (13b; 33b) of the connector system (100), wherein each pair contact point (210) has two individual contact points (220) for contacting individual contact elements of the respective differential pair contact element (13b; 33b) of the connector system (100),
- at least one first routing channel (230), through which conductor tracks (240) are routed to the individual contact points (220) of at least one of the pair contact points (210);
wherein
- a first group (G1) of the pair contact points (210) is arranged one behind the other in a first row (R1) on the printed circuit board (200),
- a second group (G2) of the pair contact points (210) is arranged one behind the other in a second row (R2) on the printed circuit board (200), wherein the second row (R2) is arranged parallel to the first row (R1),
- conductor tracks (240) are routed through the first routing channel (230) to the two individual contact points (220) of at least one of the pair contact points (210) of the first group (G1),
- the first routing channel (230) is arranged between the first row (R1) and the second row (R2) in such a way that it is arranged parallel to the first and second rows (R1, R2),
- conductor tracks (240) are routed through the first routing channel (230) to the two individual contact points (220) of all the pair contact points (210) of the first group (G1), which are not arranged at a connection end (250) of the first row (R1), with respect to which the conductor tracks (240) are routed away from the individual contact points (220) through the routing channel (230),
**characterised in that**
- the conductor tracks (240) are routed to the individual contact points (220) of the plurality of pair contact points (210) of the first group (G1) in at least three planes one above the other through the first routing channel (230), wherein the conductor tracks (240) to the individual contact points (220) of that pair contact point (210) of the first group (G1) arranged furthest away from the connection end (250) are routed in the same plane through the first routing channel (230), and the conductor tracks (240) are routed to two centre pair contact points (210) of the first group (G1), each in a different plane, through the first routing channel (230).

2. Printed circuit board (200) according to claim 1, wherein the conductor tracks (240) are routed through the first routing channel (230) at least as far as a connection end (250) of the first row (R1).

3. Printed circuit board (200) according to either one of the preceding claims, wherein an electrical shielding is formed in each case between the planes in which the conductor tracks (240) to the two individual contact points (220) of the different pair contact points (210) of the first group (G1) are routed one above the other through the first routing channel (230).

4. Printed circuit board (200) according to any one of the preceding claims having a second routing channel (232) through which conductor tracks (240) are routed to the individual contact points (220) of at least one of the pair contact points (210) of the second group (G2), wherein the second routing channel (220) is arranged adjacent to the second row (R2) such that it is arranged parallel to the first and second rows (R1, R2).

5. Printed circuit board (200) according to any one of the preceding claims having a predetermined number of rows (R1, R2) of pair contact points (210) that are arranged approximately parallel to one another, wherein
- exactly one routing channel (230; 232) is assigned to each row (R1; R2) of pair contact points (210), through which routing channel conductor tracks (240) are routed to all pair contact points (210) of the assigned row (R1; R2) not arranged at a connection end (250) of this row (R1; R2),
- these routing channels (230, 232) are arranged parallel to the rows (R1, R2) of pair contact points (210), and
- the rows (R1, R2) of pair contact points (210) and these routing channels (230, 232) are each arranged alternately next to one another, wherein the respectively assigned routing channel (230; 232) is formed next to each row (R1; R2) of pair contact points (210).

6. Printed circuit board (200) according to any one of the preceding claims having at least ten twos (R1, R2) or pair contact points (210), to each of which at least one routing channel (230; 232) is assigned.

7. Printed circuit board (200) according to any one of the preceding claims, wherein each row (R1, R2) has at least four pair contact points (210).

8. Printed circuit board (200) according to any one of the preceding claims having power contact points arranged next to the rows (R1, R2) in which the pair contact points (210) are formed, for contacting power contact elements (13c; 33c) of the connector system (100) on the card side and/or computer side.

9. Printed circuit board (200) according to any one of the preceding claims having single-end contact points arranged next to the rows (R1, R2) in which the pair contact points (210) are formed, for contacting single-end contact elements (13a; 33a) of the connector system (100) on the card side and/or computer side.

10. Printed circuit board (200) according to either one of claims 8 or 9, wherein the power contact points and/or the single-end contact points are arranged in rows parallel to the rows (R1, R2) in which the pair contact points (210) are formed.

11. Connector system (100) for connecting a PCB card to a central computer of a motor vehicle, having a computer-side connector element (10) with a plurality of computer-side differential pair contact elements (13b) and a card-side connector element (30) with a plurality of card-side differential pair contact elements (33b), having at least one printed circuit board (200) according to any one of the preceding claims for contacting the card-side and/or computer-side differential pair contact elements (13b; 33b) on the card side and/or computer side.

12. Connector system (100) according to claim 11, wherein
the computer-side connector element (10) has:
- a computer-side zinc die-cast housing (20) having at least one computer-side contact cavity (11a-11c);
- at least one computer-side insulating body (12a-12c) arranged within the at least one computer-side contact cavity (11a-11c) in the assembled state;
- a plurality of computer-side contact elements (13a-13c), which in the assembled state are arranged at least partially within computer-side insulating cavities in the at least one computer-side insulating body (12a-12c); and wherein
the card-side connector element (30) has:
- a card-side zinc die-cast housing (40) having at least one card-side contact cavity (31a-31c);
- at least one card-side insulating body (32a-32c), which in the assembled state is arranged within the at least one card-side contact cavity (31a-31c) and has a plurality of card-side insulating cavities, which are designed to at least partially receive the computer-side contact elements (13a-13c) in the assembled state; and
- a plurality of card-side contact elements (33a-33c), which in the assembled state are arranged at least partially within card-side insulating cavities and electrically contact the computer-side contact elements (13a-13c).

13. Method for producing a printed circuit board (200) for contacting a connector system (100) on the card side and/or computer side, wherein the connector system (100) is designed to connect a PCB card to a central computer of a motor vehicle, and wherein differential pair signals can be conducted through the connector system (100) along differential pair contact elements (13b, 33b) of the connector system (100), having the steps of:
- forming a plurality of pair contact points (210) for contacting differential pair contact elements (13b; 33b) of the connector system (100), wherein each pair contact point (210) has two individual contact points (220) for contacting individual contact elements of the respective differential pair contact element (13b; 33b) of the connector system (100),
- forming at least one first routing channel (230), through which conductor tracks (240) are routed to the individual contact points (220) of at least one of the pair contact points (210);
wherein
- a first group (G1) of the pair contact points (210) is arranged one behind the other in a first row (R1) on the printed circuit board (200),
- a second group (G2) of the pair contact points (210) is arranged one behind the other in a second row (R2) on the printed circuit board (200), wherein the second row (R2) is arranged parallel to the first row (R1),
- conductor tracks (240) are routed through the first routing channel (230) to the two individual contact points (220) of at least one of the pair contact points (210) of the first group (G1),
- the first routing channel (230) is arranged between the first row (R1) and the second row (R2) in such a way that it is arranged parallel to the first and second rows (R1, R2), and
- conductor tracks (240) are routed through the first routing channel (230) to the two individual contact points (220) of all the pair contact points (210) of the first group (G1), which are not arranged at a connection end (250) of the first row (R1), with respect to which the conductor tracks (240) are routed away from the individual contact points (220) through the routing channel (230),
**characterised in that**
- the conductor tracks (240) are routed to the individual contact points (220) of the plurality of pair contact points (210) of the first group (G1) in at least three planes one above the other through the first routing channel (230), wherein the conductor tracks (240) to the individual contact points (220) of that pair contact point (210) of the first group (G1) arranged furthest away from the connection end (250) are routed in the same plane through the first routing channel (230), and the conductor tracks (240) are routed to two centre pair contact points (210) of the first group (G1), each in a different plane, through the first routing channel (230).

## Revendications

1. Carte de circuit imprimé (200) pour la mise en contact côté carte et/ou côté ordinateur d'un système de connecteur (100), le système de connecteur (100) étant réalisé pour connecter une carte de circuit imprimé à un ordinateur central d'un véhicule automobile, et des signaux de paires différentielles pouvant être conduits par le système de connecteur (100) le long d'éléments de contact de paires différentielles (13b, 33b) du système de connecteur (100), avec :
- une pluralité de points de contact de paires (210) pour la mise en contact d'éléments de contact de paires différentielles (13b ; 33b) du système de connecteur (100), chaque point de contact de paires (210) présentant deux points de contact individuels (220) pour la mise en contact d'éléments de contact individuels de l'élément de contact de paires différentielles respectif (13b ; 33b) du système de connecteur (100),
- au moins un premier canal de routage (230) à travers lequel des pistes conductrices (240) sont guidées vers les points de contact individuels (220) d'au moins l'un des points de contact de paires (210) ;
- un premier groupe (G1) des points de contact de paires (210) étant agencé en série dans une première rangée (R1) sur la carte de circuit imprimé (200),
- un deuxième groupe (G2) des points de contact de paires (210) étant agencé en série dans une deuxième rangée (R2) sur la carte de circuit imprimé (200), la deuxième rangée (R2) étant agencée parallèlement à la première rangée (R1),
- des pistes conductrices (240) étant guidées à travers le premier canal de routage (230) vers les deux points de contact individuels (220) d'au moins l'un des points de contact de paires (210) du premier groupe (G1),
- le premier canal de routage (230) étant agencé entre la première rangée (R1) et la deuxième rangée (R2) de manière à être agencé parallèlement à la première et à la deuxième rangée (R1, R2), et
- des pistes conductrices (240) étant guidées à travers le premier canal de routage (230) vers les deux points de contact individuels (220) de tous les points de contact de paires (210) du premier groupe (G1), qui ne sont pas agencés à une extrémité de raccordement (250) de la première rangée (R1), vers laquelle les pistes conductrices (240) sont guidées en s'éloignant des points de contact individuels (220) par le canal de routage (230),
**caractérisé en ce que**
- les pistes conductrices (240) sont guidées vers les points de contact individuels (220) de la pluralité de points de contact de paires (210) du premier groupe (G1) dans au moins trois plans superposés à travers le premier canal de routage (230), les pistes conductrices (240) étant guidées vers les points de contact individuels (220) du point de contact de paires (210) du premier groupe (G1) qui est le plus éloigné de l'extrémité de raccordement (250) dans le même plan à travers le premier canal de routage (230), et les pistes conductrices (240) étant guidées vers deux points de contact de paires centraux (210) du premier groupe (G1) chacune dans un plan différent à travers le premier canal de routage (230).

2. Carte de circuit imprimé (200) selon la revendication 1, dans laquelle les pistes conductrices (240) sont guidées à travers le premier canal de routage (230) au moins jusqu'à une extrémité de raccordement (250) de la première rangée (R1).

3. Carte de circuit imprimé (200) selon l'une quelconque des revendications précédentes, dans laquelle un blindage électrique est réalisé entre les plans dans lesquels les pistes conductrices (240) sont guidées vers les deux points de contact individuels (220) des différents points de contact de paires (210) du premier groupe (G1), l'un au-dessus de l'autre, à travers le premier canal de routage (230).

4. Carte de circuit imprimé (200) selon l'une quelconque des revendications précédentes, avec un deuxième canal de routage (232) à travers lequel des pistes conductrices (240) sont guidées vers les points de contact individuels (220) d'au moins l'un des points de contact de paires (210) du deuxième groupe (G2), le deuxième canal de routage (220) étant agencé de manière voisine de la deuxième rangée (R2) de telle manière qu'il est agencé parallèlement aux première et deuxième rangées (R1, R2).

5. Carte de circuit imprimé (200) selon l'une quelconque des revendications précédentes, avec un nombre prédéterminé de rangées (R1, R2) de points de contact de paires (210), qui sont agencées à peu près parallèlement les unes aux autres,
- exactement un canal de routage (230 ; 232) étant associé à chaque rangée (R1 ; R2) de points de contact de paires (210), à travers lequel des pistes conductrices (240) sont guidées à tous les points de contact de paires (210) de la rangée associée (R1 ; R2) qui ne sont pas agencés à une extrémité de raccordement (250) de cette rangée (R 1 ; R2),
- ces canaux de routage (230, 232) sont agencés parallèlement aux rangées (R1, R2) de points de contact de paires (210) et
- les rangées (R1, R2) de points de contact de paires (210) et ces canaux de routage (230, 232) sont respectivement agencés en alternance les uns à côté des autres, le canal de routage respectivement associé (230 ; 232) étant réalisé à côté de chaque rangée (R1 ; R2) de points de contact de paires (210).

6. Carte de circuit imprimé (200) selon l'une quelconque des revendications précédentes, avec au moins dix rangées (R1, R2) de points de contact de paires (210), à chacune desquelles est associé au moins un canal de routage (230 ; 232).

7. Carte de circuit imprimé (200) selon l'une quelconque des revendications précédentes, dans laquelle chaque rangée (R1, R2) présente au moins quatre points de contact de paires (210).

8. Carte de circuit imprimé (200) selon l'une quelconque des revendications précédentes, avec des points de contact de puissance agencés à côté des rangées (R1, R2), dans lesquelles sont réalisés les points de contact de paires (210), pour la mise en contact côté carte et/ou côté ordinateur d'éléments de contact de puissance (13c ; 33c) du système de connecteur (100).

9. Carte de circuit imprimé (200) selon l'une quelconque des revendications précédentes, avec des points de contact d'extrémité unique agencés à côté des rangées (R1, R2) dans lesquelles sont réalisés les points de contact de paires (210), pour établir un contact côté carte et/ou côté ordinateur avec des éléments de contact d'extrémité unique (13a ; 33a) du système de connecteur (100).

10. Carte de circuit imprimé (200) selon l'une quelconque des revendications 8 ou 9, dans laquelle les points de contact de puissance et/ou les points de contact d'extrémité unique sont agencés en rangées qui sont parallèles aux rangées (R1, R2) dans lesquelles sont réalisés les points de contact de paires (210).

11. Système de connecteur (100) pour connecter une carte de circuit imprimé à un ordinateur central d'un véhicule automobile, présentant un élément de connecteur côté ordinateur (10) avec une pluralité d'éléments de contact de paires différentielles côté ordinateur (13b) et un élément de connecteur côté carte (30) avec une pluralité d'éléments de contact de paires différentielles côté carte (33b), avec au moins une carte de circuit imprimé (200) selon l'une quelconque des revendications précédentes pour la mise en contact côté carte et/ou côté ordinateur des éléments de contact de paires différentielles côté carte et/ou côté ordinateur (13b ; 33b).

12. Système de connecteur (100) selon la revendication 11, dans lequel l'élément de connecteur côté ordinateur (10) présente :
- un boîtier en zinc moulé sous pression côté ordinateur (20) avec au moins une cavité de contact côté ordinateur (11a-11c) ;
- au moins un corps isolant côté ordinateur (12a-12c) qui, à l'état monté, est agencé à l'intérieur de l'au moins une cavité de contact côté ordinateur (11 a-11 c) ;
- une pluralité d'éléments de contact côté ordinateur (13a-13c) qui, à l'état monté, sont agencés au moins par zones à l'intérieur de cavités isolantes côté ordinateur dans l'au moins un corps isolant côté ordinateur (12a-12c) ; et dans lequel
l'élément de connecteur côté carte (30) présente :
- un boîtier en zinc moulé sous pression côté carte (40) avec au moins une cavité de contact côté carte (31a-31c) ;
- au moins un corps isolant côté carte (32a-32c) qui, à l'état monté, est agencé à l'intérieur de l'au moins une cavité de contact côté carte (31a-31c) et présente une pluralité de cavités isolantes côté carte qui sont adaptées pour recevoir, à l'état monté, au moins par zone les éléments de contact côté ordinateur (13a-13c) ; et
- une pluralité d'éléments de contact côté carte (33a-33c) qui, à l'état monté, sont agencés au moins par zones à l'intérieur des cavités isolantes côté carte et sont en contact électrique avec les éléments de contact côté ordinateur (13a-30 13c).

13. Procédé de fabrication d'une carte de circuit imprimé (200) pour la mise en contact côté carte et/ou côté ordinateur d'un système de connecteur (100), le système de connecteur (100) étant réalisé pour connecter une carte de circuit imprimé à un ordinateur central d'un véhicule automobile, et des signaux de paires différentielles pouvant être conduits par le système de connecteur (100) le long d'éléments de contact de paires différentielles (13b, 33b) du système de connecteur (100), avec les étapes suivantes :
- la réalisation d'une pluralité de points de contact de paires (210) pour la mise en contact d'éléments de contact de paires différentielles (13b ; 33b) du système de connecteur (100), chaque point de contact de paires (210) présentant deux points de contact individuels (220) pour la mise en contact d'éléments de contact individuels de l'élément de contact de paires différentielles respectif (13b ; 33b) ; 33b) du système de connecteur (100),
- la réalisation d'au moins un premier canal de routage (230) à travers lequel des pistes conductrices (240) sont guidées vers les points de contact individuels (220) d'au moins l'un des points de contact de paires (210) ;
- un premier groupe (G1) des points de contact de paires (210) étant agencé en série dans une première rangée (R1) sur la carte de circuit imprimé (200),
- un deuxième groupe (G2) des points de contact de paires (210) étant agencé en série dans une deuxième rangée (R2) sur la carte de circuit imprimé (200), la deuxième rangée (R2) étant agencée parallèlement à la première rangée (R1),
- des pistes conductrices (240) étant guidées à travers le premier canal de routage (230) vers les deux points de contact individuels (220) d'au moins l'un des points de contact par paires (210) du premier groupe (G1),
- le premier canal de routage (230) étant agencé entre la première rangée (R1) et la deuxième rangée (R2) de manière à être parallèle à la première et à la deuxième rangée (R1, R2), et
- des pistes conductrices (240) étant guidées à travers le premier canal de routage (230) vers les deux points de contact individuels (220) de tous les points de contact de paires (210) du premier groupe (G1), qui ne sont pas agencés à une extrémité de raccordement (250) de la première rangée (R1), vers laquelle les pistes conductrices (240) sont guidées en s'éloignant des points de contact individuels (220) à travers le canal de routage (230),
**caractérisé en ce que**
- les pistes conductrices (240) sont guidées vers les points de contact individuels (220) de la pluralité de points de contact de paires (210) du premier groupe (G1) dans au moins trois plans superposés à travers le premier canal de routage (230), les pistes conductrices (240) étant guidées vers les points de contact individuels (220) du point de contact de paires (210) du premier groupe (G1) qui est agencé le plus loin de l'extrémité de raccordement (250) dans le même plan à travers le premier canal de routage (230), et les pistes conductrices (240) étant guidées vers deux points de contact de paires centraux (210) du premier groupe (G1) dans un autre plan respectif à travers le premier canal de routage (230).
